# EUROPEAN PATENT APPLICATION

(11) **EP 4 730 971 A1**
(43) Date of publication of application: **22.04.2026**
(21) Application number: 25204765.9
(22) Date of filing: 25.09.2025
(51) Int. Cl.: H10K 59/124, H10K 59/65, H10K 50/844

(54) **DISPLAY PANEL AND ELECTRONIC APPARATUS INCLUDING THE SAME**

(30) Priority: 26.09.2024 KR 20240131093
(71) Applicant: Samsung Display Co., Ltd., Yongin-si, Gyeonggi-do 17113 (KR)
(72) Inventor: Oh, Yuri, 17113 Yongin-si, Gyeonggi-do (KR); Lee, Jongchan, 17113 Yongin-si, Gyeonggi-do (KR); Shin, Jonghwan, 17113 Yongin-si, Gyeonggi-do (KR); Yang, Yongho, 17113 Yongin-si, Gyeonggi-d (KR); Yoo, Kibok, 17113 Yongin-si, Gyeonggi-do (KR); Lee, Donghyeok, 17113 Yongin-si, Gyeonggi-do (KR); Jeong, Kitaek, 17113 Yongin-si, Gyeonggi-do (KR); Jo, Yongseon, 17113 Yongin-si, Gyeonggi-do (KR)
(74) Representative: Gulde & Partner

(57) **Abstract**

A display panel (10) includes a substrate (100) including an upper surface (100u) and a lower surface, and defining an opening (100OP) passing through the upper (100u) and lower surfaces, an inorganic insulating structure (IL) including inorganic insulating layers above the upper surface (100u) of the substrate (100), light-emitting diodes (LED) above an upper surface of the inorganic insulating structure (IL), and defining a display area (DA) surrounding the opening (100OP) in a plan view, an encapsulation layer (300) above the light-emitting diodes (LED), and including an inorganic encapsulation layer (310, 330) and an organic encapsulation layer (320), a trench (TCH) in a non-display area (PA) between the opening (100OP) of the substrate (100) and the display area (DA), and concavely defined to have a step difference (D) with respect to the upper surface of the inorganic insulating structure (IL), an insulating layer (110) covering the step difference (D), and a metal layer (120) above the insulating layer (110), and including a first overhang portion (120P) protruding toward the trench (TCH) more than a lateral surface of the insulating layer (110).

## Description

### BACKGROUND

### 1. Field

One or more embodiments relate to a display panel having an opening area in a display area, and an electronic apparatus including the display panel.

### 2. Description of the Related Art

Recently, the usage of display apparatuses has diversified. In addition, as display apparatuses have become thinner and lighter, their range of use has been gradually extended.

Also, as the area occupied by a display area in display apparatuses is expanded, various functions that are combined or associated with display apparatuses have been added. As alternatives for adding various functions while enlarging an area, research into display apparatuses in which various elements may be located in a display area has been carried out.

### SUMMARY

One or more embodiments provide a display panel having an opening area in a display area and in which various kinds of components may be located and an electronic apparatus including the display panel. However, such a technical objective is just an example, and the disclosure is not limited thereto.

Additional aspects will be set forth in part in the description which follows and, in part, will be apparent from the description, or may be learned by practice of the presented embodiments of the disclosure.

According to one or more embodiments, a display panel includes a substrate including an upper surface, and a lower surface opposite the upper surface, and defining an opening passing through the upper surface and the lower surface, an inorganic insulating structure including inorganic insulating layers above the upper surface of the substrate, light-emitting diodes above an upper surface of the inorganic insulating structure, and defining a display area surrounding the opening in a plan view, an encapsulation layer above the light-emitting diodes, and including an inorganic encapsulation layer and an organic encapsulation layer, a trench in a non-display area between the opening of the substrate and the display area, and concavely defined to have a step difference with respect to the upper surface of the inorganic insulating structure, an insulating layer covering the step difference, and a metal layer above the insulating layer, and including a first overhang portion that protrudes toward the trench more than a lateral surface of the insulating layer.

The insulating layer may include an organic insulating material.

At least one of the light-emitting diodes may include a pixel electrode, an opposite electrode over the pixel electrode, and an intermediate layer between the pixel electrode and the opposite electrode, wherein the intermediate layer may include at least one organic material layer including a first portion on the first overhang portion, and a second portion at a bottom of the trench and separated from the first portion by the first overhang portion.

The display panel may further include a protective layer above the first overhang portion.

The display panel may further include a protective material layer in the trench, separated from the protective layer, and including a same material as the protective layer, wherein the lateral surface of the insulating layer may be inclined with respect to a bottom of the trench, and wherein the protective material layer may directly contact the lateral surface of the insulating layer.

The protective layer may include a conductive material.

An upper surface of the first overhang portion may be substantially parallel to the substrate or may be tilted downward.

The display panel may further include a partition wall in the non-display area, surrounding the opening of the substrate in the plan view, and between the trench and the display area.

The display panel may further include a first layer between the trench and the display area, and defining a groove therein, and may include a pair of second layers above the first layer, and including an overhang portion protruding toward the groove from a point at which a lower surface of one of the second layers meets an inner surface of the first layer defining a portion of the groove.

The first layer may include a same material as the insulating layer.

The second layers may include a same material as the metal layer.

According to one or more embodiments, an electronic apparatus includes a display panel and a component below the display panel and overlapping the opening area. The display panel may include an opening area, a display area surrounding the opening area in a plan view, a substrate including an upper surface, and a lower surface opposite the upper surface, and defining an opening passing through the upper surface and the lower surface and corresponding to the opening area, an inorganic insulating structure including inorganic insulating layers above the upper surface of the substrate, light-emitting diodes above an upper surface of the inorganic insulating structure, and defining the display area, an encapsulation layer above the light-emitting diodes, and including an inorganic encapsulation layer and an organic encapsulation layer, a trench in a non-display area between the opening of the substrate and the display area, and concavely defined to have a step difference with respect to the upper surface of the inorganic insulating structure, an insulating layer covering the step difference, and a metal layer above the insulating layer, and including a first overhang portion that protrudes toward the trench more than a lateral surface of the insulating layer.

The insulating layer may include an organic insulating material.

At least one of the light-emitting diodes may include a pixel electrode, an opposite electrode over the pixel electrode, and an intermediate layer between the pixel electrode and the opposite electrode, wherein the intermediate layer may include at least one organic material layer including a first portion on the first overhang portion, and a second portion at a bottom of the trench and separated from the first portion by the first overhang portion.

The display panel may further include a protective layer above the first overhang portion.

The display panel may further include a protective material layer in the trench, separated from the protective layer, and including a same material as the protective layer, wherein the lateral surface of the insulating layer may be inclined with respect to a bottom of the trench, and wherein the protective material layer may directly contact the lateral surface of the insulating layer.

The protective layer may include a conductive material.

An upper surface of the first overhang portion may be substantially parallel to the substrate or may be tilted downward.

The display panel may include a partition wall in the non-display area, surrounding the opening of the substrate in the plan view, and between the trench and the display area.

The display panel may further include a first layer between the trench and the display area, and defining a groove therein, and may include a pair of second layers above the first layer, and including an overhang portion protruding toward the groove from a point at which a lower surface of one of the second layers meets an inner surface of the first layer defining a portion of the groove.

The first layer may include a same material as the insulating layer.

The second layers may include a same material as the metal layer.

The component may include a camera or a sensor.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

The above and other aspects of embodiments of the disclosure will be more apparent from the following description taken in conjunction with the accompanying drawings, in which:
FIG. 1 is a schematic perspective view of an electronic apparatus according to one or more embodiments;
FIG. 2 is a schematic cross-sectional view of the electronic apparatus taken along the line I-I' of FIG. 1, according to one or more embodiments;
FIG. 3 is a schematic plan view of a display panel according to one or more embodiments;
FIG. 4A is a schematic equivalent circuit diagram of a light-emitting diode and a pixel circuit connected to the light-emitting diode according to one or more embodiments;
FIG. 4B is a schematic equivalent circuit diagram of a light-emitting diode and a pixel circuit electrically connected to the light-emitting diode according to one or more embodiments;
FIG. 5 is a plan view of a portion of the display panel according to one or more embodiments;
FIG. 6 is a cross-sectional view of the display panel taken along the line VI-VI' of FIG. 5, according to one or more embodiments;
FIG. 7 is a cross-sectional view of the display panel taken along the line VII-VII' of FIG. 5 according to one or more embodiments;
FIG. 8 is an excerpted cross-sectional view of a portion of a display panel according to one or more embodiments;
FIG. 9 is an excerpted cross-sectional view of a portion of a display panel according to one or more other embodiments, which may correspond to an enlarged view of a region VIII of FIG. 7;
FIG. 10A is an excerpted cross-sectional view of a portion of a display panel according to one or more embodiments, which shows an enlarged view of a region XA of FIG. 8;
FIG. 10B is an excerpted cross-sectional view of a portion of a display panel according to one or more other embodiments, corresponding to a modified one or more embodiments corresponding to FIG. 10A;
FIG. 11 is an excerpted cross-sectional view of a portion of a display panel according to one or more embodiments, which shows an enlarged view of a region XI of FIG. 7;
FIG. 12 is an excerpted cross-sectional view of a portion of a display panel according to one or more other embodiments;
FIG. 13 is an excerpted cross-sectional view of a portion of a display panel according to one or more embodiments, which shows an enlarged view of a region XIII of FIG. 7;
FIG. 14 is an excerpted cross-sectional view of a portion of a display panel according to one or more other embodiments; and
FIGS. 15A to 15G are cross-sectional views of an inner non-display area in a process of manufacturing a display panel according to one or more embodiments.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

In the drawings, the relative sizes of elements, layers, and regions may be exaggerated for clarity and/or descriptive purposes. In other words, because the sizes and thicknesses of elements in the drawings are arbitrarily illustrated for convenience of description, the disclosure is not limited thereto. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of elements, layers, or regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Spatially relative terms, such as "beneath," "below," "lower," "lower side," "under," "above," "upper," "over," "higher," "upper side," "side" (e.g., as in "sidewall"), and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic crosssection taken by vertically cutting an object portion is viewed from the side. The terms "overlap" or "overlapped" mean that a first object may be above or below or to a side of a second object, and vice versa. Additionally, the term "overlap" may include stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component (e.g., an apparatus, a device, a circuit, a wire, an electrode, a terminal, a conductive film, etc.) is referred to as being "formed on," "on," "connected to," or "(operatively, functionally, or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a transistor, a resistor, an inductor, a capacitor, a diode and/or the like. Accordingly, a connection is not limited to the connections illustrated in the drawings or the detailed description and may also include other types of connections. In describing embodiments, an expression of connection indicates electrical connection unless explicitly described to be direct connection, and "directly connected/directly coupled," or "directly on," refers to one component directly connecting or coupling another component, or being on another component, without an intermediate component.

In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XY, YZ, and XZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list. When "C to D" is stated, it means C or more and D or less, unless otherwise specified.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are only used to distinguish one element, member, component, region, area, layer, section, or portion from another element, member, component, region, area, layer, section, or portion. Thus, a first element, component, region, layer or section described below could be termed a second element, component, region, layer or section, without departing from the scope of the present disclosure as defined by the appended claims. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

When one or more embodiments may be implemented differently, a specific process order may be performed differently from the described order. For example, two consecutively described processes may be performed substantially at the same time or performed in an order opposite to the described order.

As used herein, the terms "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure." Furthermore, the expression "being the same" may mean "being substantially the same". In other words, the expression "being the same" may include a range that can be tolerated by those of ordinary skill in the art. The other expressions may also be expressions from which "substantially" has been omitted.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

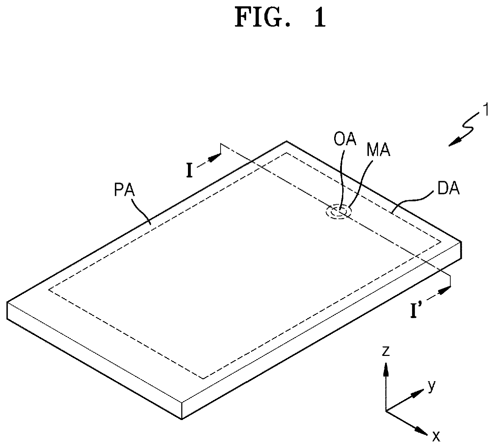

FIG. 1 is a schematic perspective view of an electronic apparatus 1 according to one or more embodiments.

Referring to FIG. 1, the electronic apparatus 1 may include an apparatus for displaying moving images or still images, and may be used as a display screen of various products including televisions, notebook computers, monitors, advertisement boards, Internet of things (loTs) as well as portable electronic apparatuses including mobile phones, smartphones, tablet personal computers (PCs), mobile communication terminals, electronic organizers, electronic books, portable multimedia players (PMPs), navigations, and ultra mobile personal computers (UMPCs). In addition, the electronic apparatus 1 may be used in wearable devices such as smartwatches, watchphones, glasses-type displays, and head-mounted displays (HMDs). In addition, in one or more embodiments, the electronic apparatus 1 may be used as a display in instrument panels for automobiles, center fascias for automobiles, or center information displays (CIDs) arranged on a dashboard, room mirror displays that replace side mirrors of automobiles, and displays of an entertainment system arranged on the backside of front seats for backseat passengers in automobiles. For convenience of description, FIG. 1 shows the case where the electronic apparatus 1 according to one or more embodiments is used as a smartphone.

The electronic apparatus 1 may have a rectangular shape in a plan view. As an example, as shown in FIG. 1, the electronic apparatus 1 may have in a plan view a quadrangular shape having short sides in the x direction, and long sides in the y direction. A corner where the short side of the x direction meets the long side of the y direction may be rounded to have a corresponding curvature (e.g., preset curvature) or may be formed to have a right angle. A planar shape of the electronic apparatus 1 is not limited to a rectangle, and may be another shape such as a polygon, ellipse, or an irregular shape.

The electronic apparatus 1 may include an opening area OA (or a first area), and a display area DA (or a second area) at least surrounding the opening area OA (e.g., in plan view). The electronic apparatus 1 may include a non-display area MA (or a third area, referred to as an inner non-display area MA hereinafter) adjacent to the opening area OA and located inside the display area DA, and a non-display area PA (or a fourth area, referred to as an outer non-display area PA, hereinafter) provided outside the display area DA. The inner non-display area MA may have a closed loop shape surrounding the opening area OA entirely in a plan view, and may be entirely surrounded by the display area DA. The outer non-display area PA may surround the display area DA entirely in a plan view.

The opening area OA may be located inside the display area DA. In one or more embodiments, the opening area OA may be located on the upper center of the display area DA as shown in FIG. 1. Alternatively, the opening area OA may be located on the upper left side of the display area DA, or the upper right side of the display area DA. However, the opening area OA may be located on various positions. Although it is shown in FIG. 1 that one opening area OA is located, a plurality of opening areas OA may be located in one or more other embodiments.

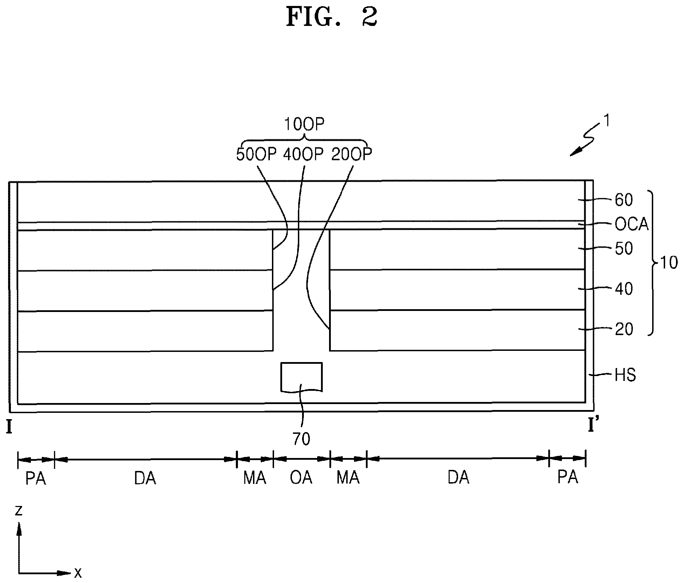

FIG. 2 is a schematic cross-sectional view of the electronic apparatus 1 taken along the line I-I' of FIG. 1, according to one or more embodiments.

Referring to FIG. 2, the electronic apparatus 1 may include a display panel 10, and a component 70 located in, or overlapping, the opening area OA of the display panel 10. The display panel 10 and the component 70 may be accommodated in a housing HS. For example, the component 70 may be below the display panel 10 and overlap the opening area OA.

The display panel 10 may include an image-generating layer 20, an input-sensing layer 40, an optical functional layer 50, and a cover window 60.

The image-generating layer 20 may include a display element (or a light-emitting element) for emitting light to display images. The display element may include, a light-emitting diode, for example, an organic light-emitting diode including an organic emission layer. In one or more other embodiments, the light-emitting diode may be an inorganic light-emitting diode including an inorganic material. The inorganic light-emitting diode may include a PN-junction diode including inorganic semiconductor-based materials. When a forward voltage is applied to a PN-junction diode, holes and electrons are injected, and light of a corresponding color (e.g., preset color) may be emitted while energy created by recombination of the holes and the electrons is converted to light energy. The inorganic light-emitting diode may have a width of several micrometers to hundreds of micrometers, or several nanometers to hundreds of nanometers. In one or more embodiments, the image-generating layer 20 may include a quantum-dot light-emitting diode. As an example, the emission layer of the image-generating layer 20 may include an organic material, an inorganic material, quantum dots, an organic material and quantum dots, or an inorganic material and quantum dots.

The input-sensing layer 40 may be configured to obtain coordinate information corresponding to an external input, for example, a touch event. The input-sensing layer 40 may include a sensing electrode (or a touch electrode) and trace lines connected to the sensing electrode. The input-sensing layer 40 may be located on the image-generating layer 20 (as used herein, "located on" may mean "above"). The input-sensing layer 40 may sense an external input by using a self-capacitance method and/or a mutual capacitance method.

The input-sensing layer 40 may be directly formed on the image-generating layer 20, or may be separately formed and then coupled to the image-generating layer 20 by using an optically clear adhesive. As an example, the input-sensing layer 40 may be successively formed after a process of forming the image-generating layer 20. In this case, an adhesive layer may not be located between the input-sensing layer 40 and the image-generating layer 20. Although it is shown in FIG. 2 that the input-sensing layer 40 is located between the image-generating layer 20 and the optical functional layer 50, the input-sensing layer 40 may be located on the optical functional layer 50.

The optical functional layer 50 may include an anti-reflection layer. The anti-reflection layer may reduce the reflectivity of light (external light) incident toward the display panel 10 from the outside through the cover window 60. The anti-reflection layer may include a phase retarder and a polarizer. In one or more other embodiments, the anti-reflection layer may include a black matrix and color filters. The color filters may be arranged by considering colors of lights emitted respectively from the light-emitting diodes of the image-generating layer 20.

To improve a transmittance of the opening area OA, the display panel 10 may include, or define, an opening 10OP passing through some of layers configuring the display panel 10. The opening 10OP may include first to third openings 20OP, 40OP, and 50OP respectively passing through the image-generating layer 20, the input-sensing layer 40, and the optical functional layer 50. The first opening 20OP of the image-generating layer 20, the second opening 40OP of the input-sensing layer 40, and the third opening 50OP of the optical functional layer 50 may overlap each other to form the opening 10OP of the display panel 10.

The cover window 60 may be located on the optical functional layer 50. The cover window 60 may be coupled to the optical functional layer 50 by an adhesive layer OCA, such as a transparent optical clear adhesive (OCA). The cover window 60 may cover the first opening 20OP of the image-generating layer 20, the second opening 40OP of the input-sensing layer 40, and the third opening 50OP of the optical functional layer 50.

The cover window 60 may include glass or plastic. The glass may include ultra-thin glass. The plastic may include polyethersulfone, polyacrylate, polyetherimide, polyethylene naphthalate, polyethylene terephthalate, polyphenylene sulfide, polyarylate, polyimide, polycarbonate, or cellulose acetate propionate.

The opening area OA may be a component area (e.g., a sensor region, a camera region, a speaker region, and/or the like) in which the component 70 for adding various functions to the electronic apparatus 1 is located.

The component 70 may include an electronic element. As an example, the component 70 may be an electronic element that uses light or sound. As an example, the electronic element may include a sensor, such as an infrared sensor that uses light, a camera that receives light to capture an image, a sensor that outputs and senses light or sound to measure a distance or recognize a fingerprint, a small lamp that outputs light, and a speaker that outputs sound. The electronic element that uses light may use light in various wavelength bands, such as visible light, infrared light, ultraviolet light and the like. The opening area OA corresponds to an area through which light and/or sound output from the component 70 to the outside or progressing toward the component 70 from the outside may pass.

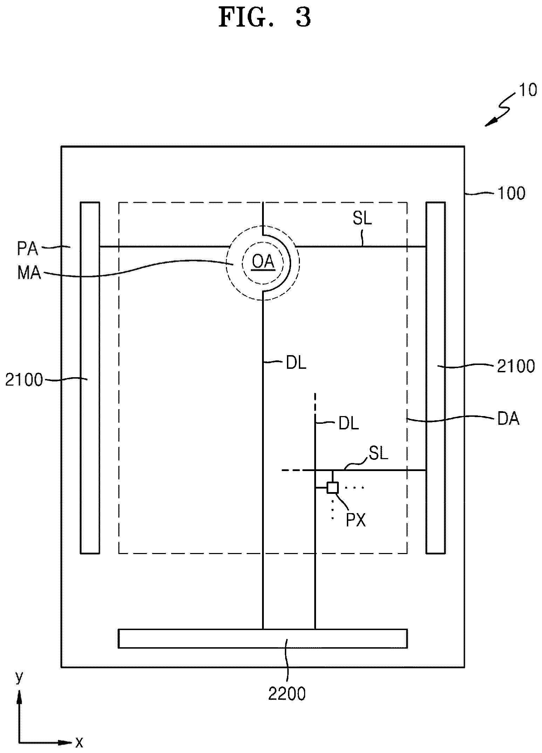

FIG. 3 is a schematic plan view of the display panel 10 according to one or more embodiments.

Referring to FIG. 3, the display panel 10 may include the opening area OA, the display area DA, the inner non-display area MA, and the outer non-display area PA.

The display panel 10 may include a plurality of pixels PX located in the display area DA, and may display images using light emitted from each of the pixels PX. Each pixel PX may emit red, green, or blue light by using a light-emitting diode. A light-emitting diode of each pixel PX may be electrically connected to a scan line SL and a data line DL.

In the outer non-display area PA, there may be arranged a scan driver 2100 for providing scan signals to each pixel PX, a data driver 2200 for providing data signals to each pixel PX, a first main power wiring and a second main power wiring for respectively providing a first power voltage and a second power voltage. The scan drivers 2100 may be respectively located on two opposite sides with the display area DA therebetween. In this case, pixels PX located on the left around the opening area OA may be connected to the scan driver 2100 located on the left, and pixels PX located on the right around the opening area OA may be connected to the scan driver 2100 located on the right.

The inner non-display area MA may surround the opening area OA. The inner non-display area MA is a region in which a display element, such as a light-emitting diode for emitting light, is not located. Signal lines may pass across the inner non-display area MA, wherein the signal lines provide signals to pixels PX provided around the opening area OA. As an example, data lines DL and/or scan lines SL cross the display area DA, and some of the data lines DL and/or scan lines SL may detour the inner non-display area MA along the edge of the opening 10OP of the display panel 10 formed in the opening area OA. In one or more embodiments, it is shown in FIG. 3 that the data lines DL cross the display area DA in a y direction, and some of the data lines DL detour the inner non-display area MA to partially surround the opening area OA. The scan lines SL cross the display area DA in an x direction, and may be apart from each other with the opening area OA therebetween.

Although it is shown in FIG. 3 that the data driver 2200 is located adjacent to one lateral side of the substrate 100, the data driver 2200 may be located on a printed circuit board electrically connected to a pad located on one side of the display panel 10 in one or more other embodiments. The printed circuit board may be flexible, and a portion of the printed circuit board may be bent to be located below the backside of the substrate 100.

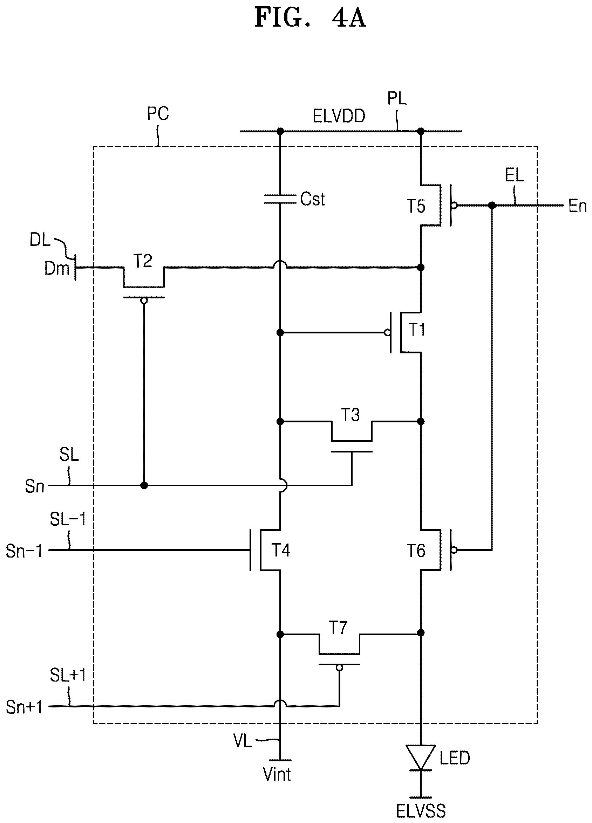

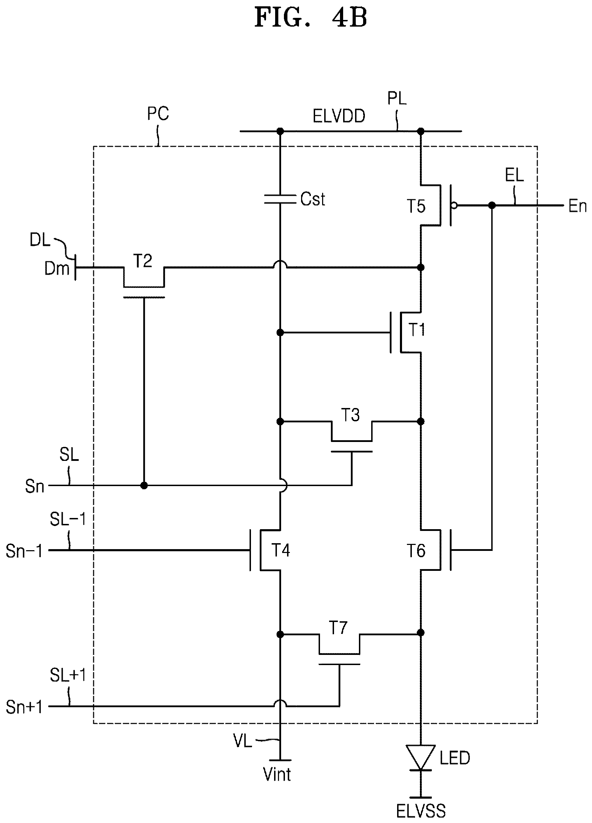

FIGS. 4A and 4B are schematic equivalent circuit diagrams of a light-emitting diode LED and a pixel circuit PC connected to the light-emitting diode LED according to one or more embodiments.

Referring to FIGS. 4A and 4B, the pixel PX described with reference to FIG. 3 may emit light using a light-emitting diode LED, and the light-emitting diode LED may be electrically connected to a pixel circuit PC.

The pixel circuit PC may include a first thin-film transistor T1, a second thin-film transistor T2, a third thin-film transistor T3, a fourth thin-film transistor T4, a fifth thin-film transistor T5, a sixth thin-film transistor T6, a seventh thin-film transistor T7, and a storage capacitor Cst.

One or more of the first to seventh thin-film transistors T1, T2, T3, T4, T5, T6, and/or T7 may be N-channel metal oxide semiconductor (NMOS) field-effect transistors (N-channel MOSFETs), and one or more of the others may be P-channel metal oxide semiconductor (PMOS) field-effect transistors (P-channel MOSFETs). In one or more embodiments, among the first to seventh thin-film transistors T1, T2, T3, T4, T5, T6, and T7, the third thin-film transistor T3 and the fourth thin-film transistor T4 may be N-channel MOSFETs, and the rest may be P-channel MOSFETs. In one or more other embodiments, as shown in FIG. 4B, among the first to seventh thin-film transistors T1, T2, T3, T4, T5, T6, and T7, the fifth thin-film transistor T5 may be a P-channel MOSFET, and the rest may be N-channel MOSFETs.

At least one of the first to seventh thin-film transistors T1, T2, T3, T4, T5, T6, or T7 may be a transistor having a low temperature polycrystalline silicon (LTPS) semiconductor layer, and at least one of the first to seventh thin-film transistors T1, T2, T3, T4, T5, T6, or T7 may be a transistor having an oxide semiconductor layer. In one or more embodiments, the third thin-film transistor T3 and the fourth thin-film transistor T4 shown in FIG. 4A may include an oxide semiconductor layer having a low leakage current, and the first, second, fifth, sixth, and seventh thin-film transistors T1, T2, T5, T6, and T7 may include a semiconductor layer including polycrystalline silicon. In one or more other embodiments, the fifth thin-film transistor T5 shown in FIG. 4B may include a semiconductor layer including polycrystalline silicon, and the first, second, third, fourth, sixth, and seventh thin-film transistors T1, T2, T3, T4, T6, and T7 may include an oxide semiconductor layer.

The second thin-film transistor T2 is a data writing thin-film transistor, may be connected to the scan line SL and the data line DL, and may be configured to transfer a data voltage (or a data signal Dm) to the first thin-film transistor T1 based on a switching voltage (or a scan signal Sn), the data voltage being input from the data line DL, and the switching voltage being input from the scan line SL. The storage capacitor Cst may be connected to the first thin-film transistor T1 and a driving voltage line PL, and may be configured to store a voltage corresponding to a difference between a data voltage transferred from the second thin-film transistor T2 and a driving voltage ELVDD supplied to the driving voltage line PL.

The first thin-film transistor T1 is a driving thin-film transistor, may be connected to the driving voltage line PL and the storage capacitor Cst, and may be configured to control a driving current according to the voltage stored in the storage capacitor Cst, the driving current flowing from the driving voltage line PL to the light-emitting diode LED. The light-emitting diode LED may be configured to emit light having a brightness (e.g., a preset brightness) corresponding to the driving current. A second electrode (e.g., a cathode) of the light-emitting diode LED may be configured to receive a common voltage ELVSS.

The third thin-film transistor T3 is a compensation thin-film transistor, and a gate electrode of the third thin-film transistor T3 may be connected to the scan line SL. A source electrode (or drain electrode) of the third thin-film transistor T3 may be connected to a drain electrode (or source electrode) of the first thin-film transistor T1, and may be connected to a first electrode of the light-emitting diode LED through the sixth thin-film transistor T6. A drain electrode (or source electrode) of the third thin-film transistor T3 may be connected to one of electrodes of the storage capacitor Cst, a source electrode (or drain electrode) of the fourth thin-film transistor T4, and a gate electrode of the first thin-film transistor T1. The third thin-film transistor T3 is turned on according to a scan signal Sn received through the scan line SL, and may diode-connect the first thin-film transistor T1 by connecting the gate electrode and the drain electrode of the first thin-film transistor T1 to each other.

The fourth thin-film transistor T4 is an initialization thin-film transistor, and a gate electrode of the fourth thin-film transistor T4 may be connected to a previous scan line SL-1. A drain electrode (or source electrode) of the fourth thin-film transistor T4 may be connected to an initialization voltage line VL. A source electrode (or drain electrode) of the fourth thin-film transistor T4 may be connected to one of the electrodes of the storage capacitor Cst, a drain electrode (or source electrode) of the third thin-film transistor T3, and the gate electrode of the first thin-film transistor T1. The fourth thin-film transistor T4 may be turned on according to a previous scan signal Sn-1 received through the previous scan line SL-1, and may perform an initialization operation of initializing the voltage of the gate electrode of the first thin-film transistor T1 by transferring an initialization voltage Vint to the gate electrode of the first thin-film transistor T1.

The fifth thin-film transistor T5 is an operation control thin-film transistor, and a gate electrode of the fifth thin-film transistor T5 may be connected to an emission control line EL. A source electrode (or drain electrode) of the fifth thin-film transistor T5 may be connected to the driving voltage line PL. A drain electrode (or source electrode) of the fifth thin-film transistor T5 is connected to the source electrode (or drain electrode) of the first thin-film transistor T1 and to a drain electrode (source electrode) of the second thin-film transistor T2.

The sixth thin-film transistor T6 is an emission control thin-film transistor, and a gate electrode of the sixth thin-film transistor T6 may be connected to the emission control line EL. A source electrode (or drain electrode) of the sixth thin-film transistor T6 is connected to the drain electrode (or source electrode) of the first thin-film transistor T1 and to a source electrode (drain electrode) of the third thin-film transistor T3. A drain electrode (source electrode) of the sixth thin-film transistor T6 may be electrically connected to the first electrode of the light-emitting diode LED. The fifth thin-film transistor T5 and the sixth thin-film transistor T6 may be concurrently or substantially simultaneously turned on according to an emission control signal En transferred through the emission control line EL, the driving voltage ELVDD is transferred to the light-emitting diode LED, and the driving current flows through the light-emitting diode LED.

The seventh thin-film transistor T7 may be an initialization thin-film transistor configured to initialize the first electrode of the light-emitting diode LED. A gate electrode of the seventh thin-film transistor T7 may be connected to a next scan line SL+1. A source electrode (drain electrode) of the seventh thin-film transistor T7 may be connected to the first electrode of the light-emitting diode LED. A drain electrode (or source electrode) of the seventh thin-film transistor T7 may be connected to the initialization voltage line VL. The seventh thin-film transistor T7 may be turned on according to a next scan signal Sn+1 transferred through the next scan line SL+1, and may initialize the first electrode of the light-emitting diode LED.

Although it is shown in FIGS. 4A and 4B that the fourth thin-film transistor T4 and the seventh thin-film transistor T7 are respectively connected to the previous scan line SL-1 and the next scan line SL+1, both the fourth thin-film transistor T4 and the seventh thin-film transistor T7 may be connected to the previous scan line SL-1 and driven according to a previous scan signal Sn-1 in one or more other embodiments.

Another electrode of the storage capacitor Cst may be connected to the driving voltage line PL. One of the electrodes of the storage capacitor Cst may be connected to the gate electrode of the first thin-film transistor T1, to the drain electrode (or source electrode) of the third thin-film transistor T3, and to the source electrode (or drain electrode) of the fourth thin-film transistor T4.

A second electrode (e.g., a cathode) of the light-emitting diode LED is configured to receive the common voltage ELVSS. The light-emitting diode LED is configured to emit light by receiving the driving current from the first thin-film transistor T1.

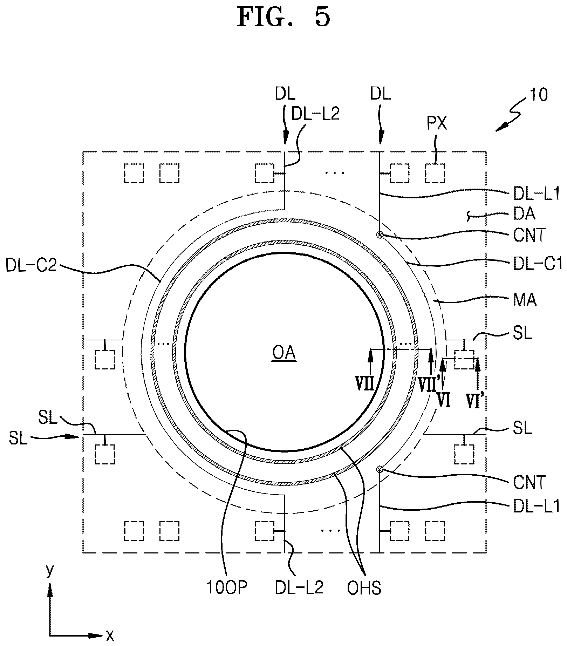

FIG. 5 is a plan view of a portion of the display panel 10 according to one or more embodiments.

Referring to FIG. 5, the pixels PX may be located in the display area DA. The inner non-display area MA may be located between the opening area OA and the display area DA. The pixels PX adjacent to the opening area OA may be apart from each other around the opening area OA in a plan view. In a plan view, the pixels PX may be vertically apart from each other around the opening area OA, or horizontally apart from each other around the opening area OA. Because each pixel PX uses red, green, or blue light emitted from the light-emitting diode, the positions of the pixels PX shown in FIG. 5 respectively correspond to the positions of the light-emitting diodes. Accordingly, when the pixels PX are apart from each other around the opening area OA in a plan view, it may represent the light-emitting diodes are apart from each other around the opening area OA in a plan view. As an example, in a plan view, the light-emitting diodes may be vertically apart from each other around the opening area OA, or horizontally apart from each other around the opening area OA.

Among signal lines configured to supply signals to the pixel circuit connected to the light-emitting diode of each pixel PX, signal lines adjacent to the opening area OA may detour around the opening area OA and/or the opening 10OP. Some of the data lines DL passing across the display area DA may extend in ±y directions to provide data signals to pixels PX vertically located with the opening area OA therebetween, and may detour along the edge of the opening area OA and/or the opening 10OP in the inner non-display area MA.

A detour portion DL-C1 of at least one data line DL among the data lines DL, and an extension portion DL-L1 crossing the display area DA, may be located on different layers, and the detour portion DL-C1 of the data line DL may be connected to the extension portion DL-L1 through a contact hole CNT. A detour portion DL-C2 of at least one data line DL among the data lines DL may be located at the same layer as an extension portion DL-L2, and may be integrally formed with the extension portion DL-L2.

The scan line SL may be separated or disconnected around the opening area OA, the scan line SL located on the left around the opening area OA may receive signals from the scan driver 2100 located on the left around the display area DA, and the scan line SL located on the right around the opening area OA may receive signals from the scan driver 2100 located on the right around the display area DA, as described above with reference to FIG. 3.

Overhang structures OHS may be located between the opening area OA and a region of the inner non-display area MA in which the data lines DL detour. In a plan view, each of the overhang structures OHS may have a closed loop shape surrounding the opening area OA, and the overhang structures OHS may be apart from each other.

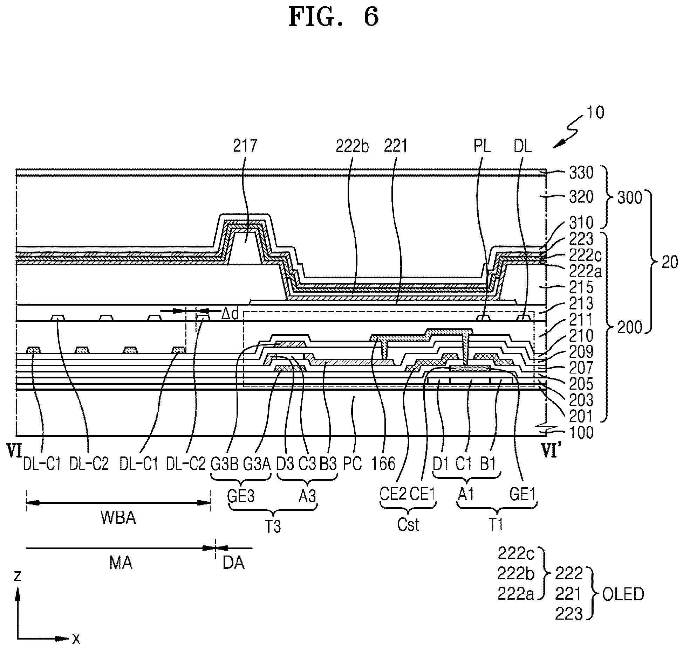

FIG. 6 is a cross-sectional view of the display panel 10 according to one or more embodiments, taken along the line VI-VI' of FIG. 5.

Referring to the display area DA of FIG. 6, the substrate 100 may include glass or polymer resin. In one or more embodiments, the substrate 100 may have a stack structure in which a base layer including polymer resin and a barrier layer including an inorganic insulating material, such as silicon oxide or silicon nitride are alternately stacked. The polymer resin may include polyethersulfone, polyarylate, polyetherimide, polyethylene naphthalate, polyethylene terephthalate, polyphenylene sulfide, polyimide, polycarbonate, cellulose tri acetate, cellulose acetate propionate, and the like.

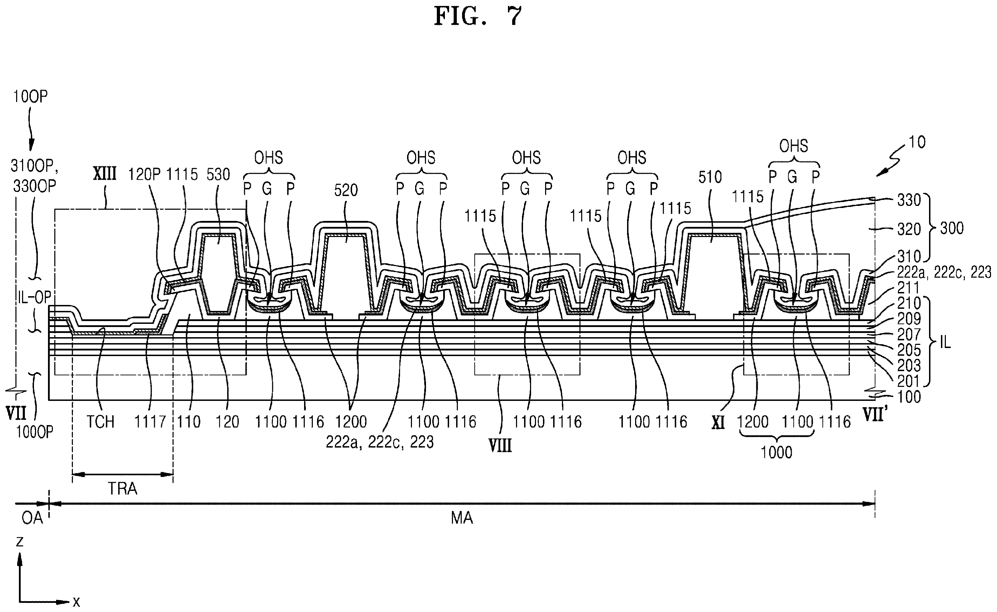

The pixel circuit PC may be formed over the substrate 100, and the light-emitting diode, for example, an organic light-emitting diode OLED may be located on the pixel circuit PC. The organic light-emitting diode OLED may be located on an inorganic insulating structure IL (see FIG. 7) described below.

A buffer layer 201 may be formed on the substrate 100 (e.g., before the pixel circuit PC is formed) to reduce or prevent impurities from penetrating to the pixel circuit PC. The buffer layer 201 may include an inorganic insulating material, such as silicon nitride, silicon oxynitride, and/or silicon oxide, and may include a single-layered structure or a multi-layered structure including the above inorganic insulating materials.

As described above with reference to FIG. 4A or 4B, the pixel circuit PC may include the plurality of transistors and the storage capacitor. With regard to this, FIG. 6 shows the first thin-film transistor T1, the third thin-film transistor T3, and the storage capacitor Cst.

The first thin-film transistor T1 may include a semiconductor layer (referred to as a first semiconductor layer A1, hereinafter) on the buffer layer 201, and a gate electrode (referred to as a first gate electrode GE1, hereinafter) overlapping a channel region C1 of the first semiconductor layer A1. The first semiconductor layer A1 may include a silicon-based semiconductor material, for example, polycrystalline silicon. The first semiconductor layer A1 may include the channel region C1, and a first region B1 and a second region D1 respectively located on two opposite sides of the channel region C1. The first region B1 and the second region D1 are regions including impurities of higher concentration than that of the channel region C1. One of the first region B1 and the second region D1 may correspond to a source region, and the other may correspond to a drain region.

A first gate-insulating layer 203 may be located between the first semiconductor layer A1 and the first gate electrode GE1. The first gate-insulating layer 203 may include an inorganic insulating material, such as silicon nitride, silicon oxynitride, and silicon oxide, and may include a single-layered structure or a multi-layered structure including the above inorganic insulating materials.

The first gate electrode GE1 may include a conductive material including molybdenum (Mo), aluminum (Al), copper (Cu), and/or titanium (Ti), and may have a single-layered structure or a multi-layered structure including the above materials.

The storage capacitor Cst may include a lower electrode CE1 and an upper electrode CE2 overlapping each other. In one or more embodiments, the lower electrode CE1 of the storage capacitor Cst may include the first gate electrode GE1. In other words, the first gate electrode GE1 may include the lower electrode CE1 of the storage capacitor Cst. As an example, the first gate electrode GE1 and the lower electrode CE1 of the storage capacitor Cst may be integrally formed.

A first interlayer insulating layer 205 may be located between the lower electrode CE1 and the upper electrode CE2 of the storage capacitor Cst. The first interlayer insulating layer 205 may include an inorganic insulating material, such as silicon nitride, silicon oxynitride, and silicon oxide, and may include a single-layered structure or a multi-layered structure including the above inorganic insulating materials.

The upper electrode CE2 of the storage capacitor Cst may include a conductive material of a low-resistance material, such as molybdenum (Mo), aluminum (Al), copper (Cu) and/or titanium (Ti), and may have a single-layered structure or a multi-layered structure including the above materials.

A second interlayer insulating layer 207 may be located on the storage capacitor Cst. The second interlayer insulating layer 207 may include an inorganic insulating material, such as silicon nitride, silicon oxynitride, and/or silicon oxide, and may include a single-layered structure or a multi-layered structure including the above inorganic insulating materials.

A semiconductor layer (referred to as a third semiconductor layer A3, hereinafter) of the third thin-film transistor T3 may be located on the second interlayer insulating layer 207. The third semiconductor layer A3 may include an oxide-based semiconductor material. As an example, the third semiconductor layer A3 may include Zn-oxide-based material, for example, include Zn-oxide, In-Zn oxide, and/or Ga-In-Zn oxide. In one or more embodiments, the third semiconductor layer A3 may include In-Ga-Zn-O (IGZO), In-Sn-Zn-O (ITZO), or In-Ga-Sn-Zn-O (IGTZO) semiconductor-containing metal, such as indium (In), gallium (Ga), and/or stannum (Sn) in ZnO.

The third semiconductor layer A3 may include a channel region C3, and a first region B3 and a second region D3 respectively located on two opposite sides of the channel region C3. One of the first region B3 and the second region D3 may correspond to a source region, and the other of the first region B3 and the second region D3 may correspond to a drain region.

The third thin-film transistor T3 may include a gate electrode (referred to as a third gate electrode GE3, hereinafter) overlapping the channel region C3 of the third semiconductor layer A3. The third gate electrode GE3 may have a double-gate structure including a lower gate electrode G3A and an upper gate electrode G3B, wherein the lower gate electrode G3A is below the third semiconductor layer A3, and the upper gate electrode G3B is over the channel region C3.

The lower gate electrode G3A may be located at the same layer (e.g., on the first interlayer insulating layer 205) as the upper electrode CE2 of the storage capacitor Cst. The lower gate electrode G3A may include the same material as the upper electrode CE2 of the storage capacitor Cst.

The upper gate electrode G3B may be located over the third semiconductor layer A3 with a second gate-insulating layer 209 therebetween. The second gate-insulating layer 209 may include an inorganic insulating material, such as silicon nitride, silicon oxynitride, and/or silicon oxide, and may include a single-layered structure or a multi-layered structure including the above inorganic insulating materials.

A third interlayer insulating layer 210 may be located on the upper gate electrode G3B. The third interlayer insulating layer 210 may include an inorganic insulating material, such as silicon oxynitride, and may have a single layer or a multi-layer including the inorganic insulating materials.

FIG. 6 shows the first thin-film transistor T1 and the third thin-film transistor T3 described with reference to FIG. 4A, and shows that the first semiconductor layer A1 and the third semiconductor layer A3 are located on different layers. In one or more embodiments, the second, fifth, sixth, and seventh thin-film transistors T2, T5, T6, and T7 (see FIG. 4A) may have the same structure as that of the first thin-film transistor T1 described with reference to FIG. 6. As an example, the second, fifth, sixth, and seventh thin-film transistors T2, T5, T6, and T7 (see FIG. 4A) may include a semiconductor layer located at the same layer (e.g., on the buffer layer 201) as the first semiconductor layer A1 of the first thin-film transistor T1, and a gate electrode located at the same layer (e.g., on the first gate-insulating layer 203) as the first gate electrode GE1 of the first thin-film transistor T1. A semiconductor layer of the second, fifth, sixth, and seventh thin-film transistors T2, T5, T6, and T7 (see FIG. 4A) may be integrally connected to the first semiconductor layer A1.

Although it is shown in FIG. 6 that the first semiconductor layer A1 and the third semiconductor layer A3 are located on different layers, the disclosure is not limited thereto. In one or more other embodiments, in the case where the first thin-film transistor T1 and the third thin-film transistor T3 are the same NMOS transistors as in FIG. 4B, the first semiconductor layer A1 may be located at the same layer as the third semiconductor layer A3, that is, on the second interlayer insulating layer 207. Further, a semiconductor layer of the fifth thin-film transistor T5 of FIG. 4B may be a semiconductor layer including polycrystalline silicon, and may be located on the buffer layer 201. Hereinafter, for convenience of description, a case where the first semiconductor layer A1 of the first thin-film transistor T1 includes polycrystalline silicon, and the third semiconductor layer A3 of the third thin-film transistor T3 includes an oxide semiconductor is described.

The first thin-film transistor T1 may be electrically connected to the third thin-film transistor T3 through a node connection line 166. The node connection line 166 may be located on the third interlayer insulating layer 210. One side of the node connection line 166 may be connected to the first gate electrode GE1 of the first thin-film transistor T1, and another side of the node connection line 166 may be connected to the third semiconductor layer A3 of the third thin-film transistor T3.

The node connection line 166 may include aluminum (Al), copper (Cu), and/or titanium (Ti), and may include a single layer or a multi-layer including the above materials. As an example, the node connection line 166 may have a triple-layered structure of titanium layer/aluminum layer/titanium layer.

A first organic insulating layer 211 may be located on the node connection line 166. The first organic insulating layer 211 may include an organic insulating material. The organic insulating material may include acryl, benzocyclobutene (BCB), polyimide, or hexamethyldisiloxane (HMDSO).

The data line DL and the driving voltage line PL may be located on the first organic insulating layer 211, and may be covered by a second organic insulating layer 213. The data line DL and the driving voltage line PL may include aluminum (Al), copper (Cu), and/or titanium (Ti), and may include a single layer or a multi-layer including the above materials. As an example, the data line DL and the driving voltage line PL may each have a triple-layered structure of titanium layer/aluminum layer/titanium layer.

The second organic insulating layer 213 may include acryl, BCB, polyimide, and/or HMDSO. Although it is shown in FIG. 6 that the data line DL and the driving voltage line PL are formed on the first organic insulating layer 211, the disclosure is not limited thereto. In one or more other embodiments, one of the data line DL and the driving voltage line PL may be located at the same layer as the node connection line 166.

A light-emitting diode, for example, the organic light-emitting diode OLED may be located on the second organic insulating layer 213.

A pixel electrode 221 of the organic light-emitting diode OLED may include a reflective layer including silver (Ag), magnesium (Mg), aluminum (Al), platinum (Pt), palladium (Pd), gold (Au), nickel (Ni), neodymium (Nd), iridium (Ir), chrome (Cr), or a compound thereof. In one or more other embodiments, the pixel electrode 221 may further include a conductive oxide material layer on and/or under the reflective layer. The conductive oxide material layer may include indium tin oxide (ITO), indium zinc oxide (IZO), zinc oxide (ZnO), indium oxide (In₂O₃), indium gallium oxide (IGO), and/or aluminum zinc oxide (AZO). In one or more embodiments, the pixel electrode 221 may have a triple-layered structure of ITO layer/Ag layer/ITO layer.

A bank layer 215 may be located on the pixel electrode 221. The bank layer 215 may include, or define, an opening that overlaps the pixel electrode 221, and may cover the edges of the pixel electrode 221. The bank layer 215 may include an organic insulating material.

An intermediate layer 222 includes an emission layer 222b. The intermediate layer 222 may include a first functional layer 222a and/or a second functional layer 222c, wherein the first functional layer 222a is under the emission layer 222b, and the second functional layer 222c is on the emission layer 222b. The emission layer 222b may include a polymer organic material or a low-molecular weight organic material configured to emit light having a corresponding color (e.g., preset color). The first functional layer 222a may include a hole transport layer (HTL) and/or a hole injection layer (HIL). The second functional layer 222c may include an electron transport layer (ETL) and/or an electron injection layer (EIL). The first functional layer 222a and the second functional layer 222c may each include an organic material.

An opposite electrode 223 may include a conductive material having a low work function. As an example, the opposite electrode 223 may include a (semi) transparent layer including silver (Ag), magnesium (Mg), aluminum (Al), platinum (Pt), palladium (Pd), gold (Au), nickel (Ni), neodymium (Nd), iridium (Ir), chrome (Cr), or an alloy thereof. Alternatively, the opposite electrode 223 may further include a layer on the (semi) transparent layer, the layer including ITO, IZO, ZnO, or In₂O₃.

The emission layer 222b may be formed in the display area DA to overlap the pixel electrode 221 through the opening of the bank layer 215. In contrast, the first functional layer 222a, the second functional layer 222c, and the opposite electrode 223 may extend to be located in not only the display area DA, but also in the inner non-display area MA.

A spacer 217 may be formed on the bank layer 215. The spacer 217 may be formed together during the same process as the forming the bank layer 215, or may be formed separately during a separate process. In one or more embodiments, the spacer 217 may include an organic insulating material, such as polyimide.

The organic light-emitting diode OLED may be covered by an encapsulation layer 300. The encapsulation layer 300 may include at least one organic encapsulation layer and at least one inorganic encapsulation layer. In one or more embodiments, it is shown in FIG. 6 that the encapsulation layer 300 includes first and second inorganic encapsulation layers 310 and 330, and an organic encapsulation layer 320 therebetween.

The first and second inorganic encapsulation layers 310 and 330 may include at least one inorganic material selected from aluminum oxide, titanium oxide, tantalum oxide, hafnium oxide, zinc oxide, silicon oxide, silicon nitride, silicon oxynitride, or the like. The first and second inorganic encapsulation layers 310 and 330 may include a single layer or a multi-layer including the above materials. The organic encapsulation layer 320 may include a polymer-based material. The polymer-based material may include an acryl-based resin, an epoxy-based resin, polyimide, and polyethylene. In one or more embodiments, the organic encapsulation layer 320 may include acrylate.

The thickness of the first inorganic encapsulation layer 310 may be different from that of the second inorganic encapsulation layer 330. The thickness of the first inorganic encapsulation layer 310 may be greater than that of the second inorganic encapsulation layer 330. Alternatively, the thickness of the second inorganic encapsulation layer 330 may be greater than that of the first inorganic encapsulation layer 310, or the thickness of the first inorganic encapsulation layer 310 may be the same as that of the second inorganic encapsulation layer 330.

The display panel 10 may include the substrate 100 and the image-generating layer 20, and the image-generating layer 20 may include a circuit-diode layer 200 located on the substrate 100 and including pixel circuits PC and light-emitting diodes and the encapsulation layer 300. As described above with reference to FIG. 2, the input-sensing layer 40 (see FIG. 2), the optical functional layer 50 (see FIG. 2), and the like may be further located on the image-generating layer 20.

Referring to the inner non-display area MA of FIG. 6, the inner non-display area MA may include a line bypass area WBA through which the detour portions DL-C1 and DL-C2 of the data lines DL described above with reference to FIG. 5 pass.

The detour portions DL-C1 and DL-C2 of the data lines DL may be located on different layers. One of the detour portions DL-C1 and DL-C2 of adjacent data lines DL may be located on the third interlayer insulating layer 210, and the other may be located on the first organic insulating layer 211.

In the case where the detour portions DL-C1 and DL-C2 of the data lines DL are alternately located with an insulating layer (e.g., a first organic insulating layer 211) therebetween, a pitch Δd between the detour portions DL-C1 and DL-C2 of the data lines DL may be reduced, and thus, an area in the inner non-display area MA may be efficiently utilized.

FIG. 7 is a cross-sectional view of the display panel 10 according to one or more embodiments, taken along the line VII-VII' of FIG. 5. Referring to FIGS. 5 and 7, the display panel 10 may include/define the opening 10OP corresponding to the opening area OA, and the inner non-display area MA may include structures for reducing or preventing propagation of cracks and/or moisture transmission. The opening 10OP of the display panel 10 may be formed by passing through the various layers configuring the display panel 10. With regard to this, FIG. 7 shows an opening 100OP passing through a first surface (referred to as an upper surface, hereinafter) and a second surface (referred to as a lower surface, hereinafter) of the substrate 100, an opening IL-OP passing through an upper surface and a lower surface of an inorganic insulating structure IL, and openings 310OP and 330OP of the first and second inorganic encapsulation layers 310 and 330. The inorganic insulating structure IL is a stack structure including a plurality of inorganic insulating layers. In one or more embodiments, as shown in FIG. 7, the inorganic insulating structure IL may include the buffer layer 201, the first gate-insulating layer 203, the first interlayer insulating layer 205, the second interlayer insulating layer 207, the second gate-insulating layer 209, and the third interlayer insulating layer 210.

Although FIG. 7 shows, for convenience of description, a stack structure from the substrate 100 to the encapsulation layer 300, as described above with reference to FIG. 2, the display panel 10 may further include the input-sensing layer 40, the optical functional layer 50, the cover window 60, and the like on the encapsulation layer 300, and the input-sensing layer 40 and the optical functional layer 50 may respectively include openings corresponding to the opening area OA.

Referring to FIGS. 5 and 7, a trench TCH, overhang structures OHS, and first to third partition walls 510, 520, and 530 may be located in the inner non-display area MA. The encapsulation layer 300 may extend to the inner non-display area MA, and may overlap or cover the trench TCH, the overhang structures OHS, the first and second partition walls 510 and 520, and the like.

The overhang structures OHS may be apart from each other in the inner non-display area MA. In one or more embodiments, referring to FIGS. 5 and 7, one overhang structure OHS may be located between the first partition wall 510 and the display area DA (see FIG. 5), a plurality of overhang structures OHS may be located between the first partition wall 510 and the second partition wall 520, and at least one overhang structure OHS may be located between the second partition wall 520 and the third partition wall 530. Although FIG. 7 shows one overhang structure OHS between the second partition wall 520 and the third partition wall 530, the disclosure is not limited thereto. In one or more other embodiments, a plurality of overhang structures OHS may be located between the second partition wall 520 and the third partition wall 530.

As shown in FIG. 5, each of the overhang structures OHS may have a closed loop shape surrounding the opening area OA in a plan view. In a plan view, when "A" has a closed loop shape surrounding the opening area OA, it may represent that "A" has a closed loop shape surrounding the opening 100OP of the substrate 100 in a plan view. Accordingly, when each of the overhang structures OHS may have a closed loop shape surrounding the opening area OA in a plan view, it may represent that each of the overhang structures OHS may have a closed loop shape surrounding the opening 100OP of the substrate 100 in a plan view.

The overhang structure OHS may be defined in a multi-layer 1000 including a first layer 1100 and a second layer 1200 respectively including different materials. The second layer 1200 may be located on the first layer 1100, and may have a thickness that is less than that of the first layer 1100. The overhang structure OHS may include, or define, a groove G defined in the first layer 1100, and an overhang portion P hanging over the groove G to have an eave structure. In one or more embodiments, as shown in FIG. 7, the overhang structure OHS may include the groove G defined in the first layer 1100, and two overhang portions P protruding toward each other over the groove G.

The first layer 1100 may include an insulating material. In one or more embodiments, the first layer 1100 may include an organic insulating material. As an example, a material of the first layer 1100 may be the same as a material of the first organic insulating layer 211 described with reference to FIG. 6. The groove G is a portion recessed in a thickness direction of the first layer 1100, and a depth of the groove G may be less than the thickness of the first layer 1100.

The first layer 1100 may be apart from each other in the inner non-display area MA. Like the overhang structure OHS, the first layer 1100 may have a closed loop shape surrounding the opening area OA and/or the opening 100OP of the substrate 100.

The second layer 1200 may include a conductive material. In one or more embodiments, the second layer 1200 may be a metal layer including a metal material including molybdenum (Mo), aluminum (Al), copper (Cu), titanium (Ti), and/or the like. The second layer 1200 may include a single-layered or multi-layered structure including the above materials. In one or more embodiments, the second layer 1200 may have a three-layered stack structure of a titanium layer/an aluminum layer/a titanium layer. As an example, the second layer 1200 may be formed during the same process as the forming the data line DL and/or the driving voltage line PL described with reference to FIG. 6, and may include the same material as the data line DL and/or the driving voltage line PL.

Two second layers 1200 may be respectively located on two opposite sides of the groove G. Overhang portions P of the two second layers 1200 may protrude toward each other over the groove G to have an eave shape. As an example, the two overhang portions P located on two opposite sides of the groove G may extend toward each other while maintaining a gap.

A second layer 1200 located on one first layer 1100 may be integrally connected to a second layer 1200 located on another first layer 1100 located adjacent thereto. In other words, one second layer 1200 may include two overhang portions P respectively extending over two adjacent first layers 1100, and extending over the groove G of each of the two first layers 1100. The second layer 1200 may be in contact with the upper surface of an uppermost layer (e.g., an inorganic insulating layer located directly under the first layer 1100) of the inorganic insulating structure IL exposed between two adjacent first layers 1100.

A protective layer 1115 may be located on the overhang portion P, and may protect the overhang portion P. The protective layer 1115 may be located on the upper surface and on the lateral surface of the overhang portion P. For example, protective layer 1115 may be in direct contact with the upper surface and the lateral surface of the overhang portion P. The protective layer 1115 may include a conductive material. In one or more embodiments, the protective layer 1115 may include the same material as that of the pixel electrode 221 described with reference to FIG. 6. The protective layer 1115 may have a triple-layered structure of ITO layer/Ag layer/ITO layer. During the process of forming the protective layer 1115, there may be a first material layer 1116 (referred to as a first protective material layer 1116, hereinafter), which is the same as the protective layer 1115, at a bottom of the groove G (e.g., on a surface of a corresponding first layer 1100 at a bottom of, or below, the groove G).

Among the layers included in the organic light-emitting diode OLED (see FIG. 6), a layer including an organic material, for example, the first functional layer 222a and/or the second functional layer 222c, may be formed in not only the display area DA, but also the inner non-display area MA. As a comparative example, the first functional layer 222a and the second functional layer 222c continuously formed in the inner non-display area MA may provide a moisture transmission path of moisture introduced through the opening 10OP of the display panel 10, and the organic light-emitting diode OLED (see FIG. 6) may be damaged by the moisture.

In contrast, in embodiments, among the layers included in the light-emitting diode, the first functional layer 222a and/or the second functional layer 222c including an organic material is separated into a plurality of portions by the overhang structure OHS in the inner non-display area MA. Accordingly, because a progression path of moisture introduced through the opening area OA is blocked, damage to the organic light-emitting diode OLED (see FIG. 6) may be reduced or prevented. Similarly, the opposite electrode 223 may be separated into a plurality of portions by the overhang structure OHS in the inner non-display area MA. With regard to this, FIG. 7 shows each of the first functional layer 222a, the second functional layer 222c, and the opposite electrode 223 is separated into a plurality of portions in the inner non-display area MA. Each of the first functional layer 222a, the second functional layer 222c, and the opposite electrode 223 may be separated into a portion located on the overhang portion P, and a portion at a bottom of the groove G (e.g., on the first material layer 1116 at the bottom of, or below, the groove G).

The inner non-display area MA may include a trench area TRA relatively closer to the opening area OA. The trench area TRA is a region in which the trench TCH defined in the inorganic insulating structure IL is located, and the trench TCH may have a shape recessed in the thickness direction of the inorganic insulating structure IL. Because the display panel 10 includes the trench TCH defined in the inorganic insulating structure IL, impacts (e.g., impacts and the like that occur during a process of forming the opening 10OP of the display panel 10) that may occur during the process of manufacturing the display panel 10, and cracks according to the impacts, may be reduced or may be prevented from being transferred to the display area DA.

The trench TCH may be located between the opening area OA and a partition wall located closest to the opening area OA among the partition walls. With regard to this, FIG. 7 shows the trench TCH is located between the third partition wall 530 and the opening area OA. The width of the trench TCH may be greater than the width of the groove G of the first layer 1100. The depth of the trench TCH may be less than a sum of thicknesses of the inorganic insulating structure IL. In one or more embodiments, although it is shown in FIG. 7 that the trench TCH passes through the upper surface and lower surface of the third interlayer insulating layer 210, the upper surface and lower surface of the second gate-insulating layer 209, and the upper surface of the second interlayer insulating layer 207, the disclosure is not limited thereto.

The trench TCH is a concave portion forming a step difference with respect to the upper surface of the inorganic insulating structure IL. Two opposite sides of the trench TCH may form a step difference with respect to the upper surface of the inorganic insulating structure IL. The trench TCH may include a first edge portion relatively closer to the opening area OA, and a second edge portion that is opposite to the first edge portion. Each of the first edge portion and the second edge portion may form a step difference with respect to the upper surface of the inorganic insulating structure IL.

An insulating layer 110 may cover the step difference. As an example, the insulating layer 110 may cover a step difference (e.g., a step difference between the second edge portion of the trench TCH and the upper surface of the inorganic insulating structure IL) located relatively away from the opening area OA.

The insulating layer 110 may include an organic insulating material. In one or more embodiments, the insulating layer 110 may be formed concurrently or substantially simultaneously during a process of forming the first layer 1100, and may include the same material as the first layer 1100. A portion of the insulating layer 110 may be located on the upper surface of the inorganic insulating structure IL, and another portion may be located on the trench TCH.

A metal layer 120 may be located on the insulating layer 110. The metal layer 120 may be formed concurrently or substantially simultaneously during a process of forming the second layer 1200, and may include the same material as the second layer 1200. The metal layer 120 may include a first overhang portion 120P that protrudes further toward the trench TCH than the lateral surface of the insulating layer 110. Similar to the overhang portion P of the overhang structure OHS described above, each of the first functional layer 222a, the second functional layer 222c, and the opposite electrode 223 may be separated into a plurality of portions by the first overhang portion 120P. With regard to this, it is shown in FIG. 7 that each of the first functional layer 222a, the second functional layer 222c, and the opposite electrode 223 includes a portion located on the first overhang portion 120P and a portion located at the bottom of the trench TCH.

In one or more embodiments, as shown in FIG. 7, the metal layer 120 may be integrally connected to the second layer 1200 of the overhang structure OHS adjacent thereto, and the third partition wall 530 may be located on a connection portion of the second layer 1200 adjacent to the metal layer 120. In one or more other embodiments, the metal layer 120 may be separated from the second layer 1200 of the overhang structure OHS adjacent thereto.

The first overhang portion 120P of the metal layer 120 may be protected by the protective layer 1115. The protective layer 1115 may be located on the upper surface and on the lateral surface of the first overhang portion 120P. During the process of forming the protective layer 1115, there may be a second material layer 1117 (referred to as a second protective material layer 1117, hereinafter), which is the same as the protective layer 1115, at a bottom of the trench TCH.

The encapsulation layer 300 may extend to not only the display area DA (see FIG. 5), but also to the inner non-display area MA. Each of the first inorganic encapsulation layer 310 and the second inorganic encapsulation layer 330 may be located on, or in, the trench TCH, on the overhang structure OHS, on the first partition wall 510, on the second partition wall 520, and on the third partition wall 530. Each of the first inorganic encapsulation layer 310 and the second inorganic encapsulation layer 330 may extend toward the opening area OA through the trench area TRA. The first inorganic encapsulation layer 310 may continuously cover the upper surface, the lateral surface, and the bottom surface of the overhang portion P, and an inner surface of the first layer 1100 defining the groove G, and may continuously cover the upper surface, the lateral surface, and the bottom surface of the first overhang portion 120P.

A partition wall is intended to control a flow of monomer when forming the organic encapsulation layer 320. The organic encapsulation layer 320 may overlap some of the overhang structures OHS, for example, an overhang structure OHS between one of the partition walls and the display area DA (see FIG. 5). In one or more embodiments, it is shown in FIG. 7 that the organic encapsulation layer 320 overlaps an overhang structure OHS between the first partition wall 510 and the display area DA (see FIG. 5).

The overhang structure OHS between the first partition wall 510 and the display area DA (see FIG. 5) may overlap the first inorganic encapsulation layer 310, the organic encapsulation layer 320, and the second inorganic encapsulation layer 330.

The second inorganic encapsulation layer 330 may be in direct contact with the first inorganic encapsulation layer 310 in a partial region of the inner non-display area MA. As an example, the second inorganic encapsulation layer 330 may be in direct contact with the first inorganic encapsulation layer 310 between the first partition wall 510 and the opening area OA. In one or more embodiments, as shown in FIG. 7, a portion of the second inorganic encapsulation layer 330 may be in direct contact with a portion of the first inorganic encapsulation layer 310 over the overhang structures OHS between the first partition wall 510 and the second partition wall 520, over the overhang structure OHS between the second partition wall 520 and the third partition wall 530, and over the first overhang portion 120P and the trench TCH between the third partition wall 530 and the opening area OA. A portion of the second inorganic encapsulation layer 330 may be in direct contact with a portion of the first inorganic encapsulation layer 310 on the first to third partition walls 510, 520, and 530.

Each of the first and second partition walls 510 and 520 may be located between adjacent overhang structures OHS. The first partition wall 510 may cover an end of each of the second layers 1200 located on two opposite sides of the first partition wall 510 and extending to the upper surface of the inorganic insulating structures IL, and may cover an end of the protective layer 1115 located on the second layers 1200. The second partition wall 520 may cover an end of each of the second layers 1200 located on two opposite sides of the second partition wall 520 and extending to the upper surface of the inorganic insulating structures IL, and may cover an end of the protective layer 1115 located on the second layers 1200. Each of the first to third partition walls 510, 520, and 530 may have a closed loop shape surrounding the opening area OA in a plan view. In one or more embodiments, the width of the first partition wall 510 may be greater than the width of the second partition wall 520. The width of the second partition wall 520 may be greater than the width of the third partition wall 530.

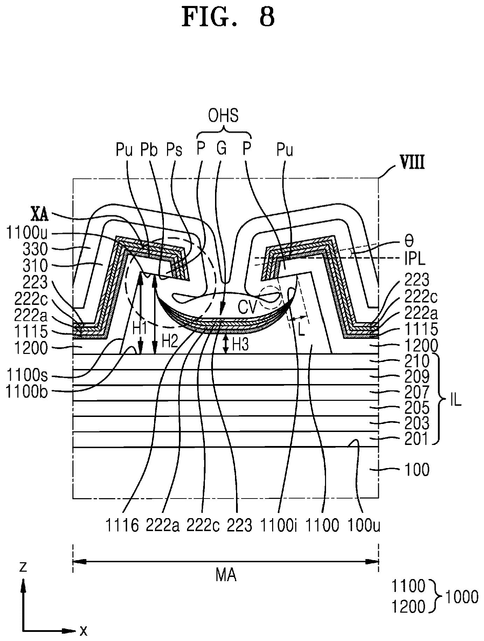

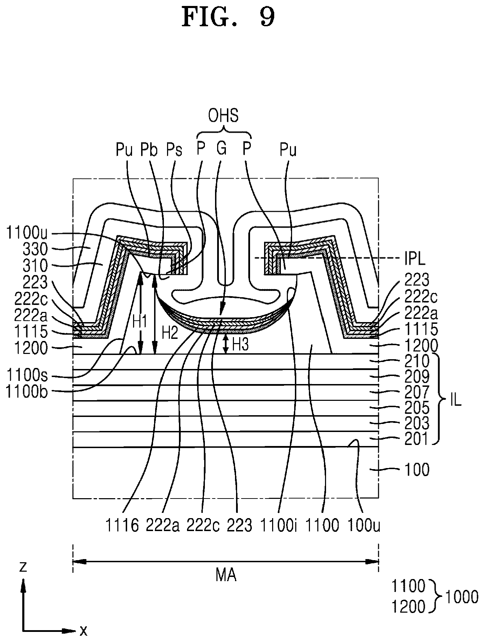

FIG. 8 is an excerpted cross-sectional view of a portion of the display panel 10 according to one or more embodiments, and is an enlarged view of a region VIII of FIG. 7. FIG. 9 is an excerpted cross-sectional view of a portion of the display panel 10 according to one or more other embodiments, corresponding to an enlarged view of a region VIII of FIG. 7. Although the overhang structure OHS shown in FIGS. 8 and 9 shows the overhang structure OHS located between adjacent partition walls, for example, between the first partition wall 510 (see FIG. 7) and the second partition wall 520 (see FIG. 7), the disclosure is not limited thereto. A structure of the overhang structure OHS shown in FIGS. 8 and 9 may be the same as that of the overhang structure OHS located between the second partition wall 520 and the third partition wall 530 (see FIG. 7).

Referring to FIGS. 8 and 9, the overhang structure OHS may be located on the inorganic insulating structure IL. The overhang structure OHS may be defined in the multi-layer 1000, and the multi-layer 1000 may include different materials, and may include the first layer 1100 and the second layer 1200 respectively having different thicknesses. The first layer 1100 may include an insulating material, and the second layer 1200 may include a conductive material. In one or more embodiments, the first layer 1100 may include an organic insulating material, may include acryl, BCB, polyimide, or HMDSO, and may include a single layer or a multi-layer including the above materials. The second layer 1200 may include aluminum (Al), copper (Cu), and/or titanium (Ti), and may include a single layer or a multi-layer including the above materials.

The first layer 1100 may be located on an uppermost layer of the inorganic insulating structure IL, for example, the third interlayer insulating layer 210. The first layer 1100 may include a lower surface 1100b, an inner surface 1100i, a side surface 1100s, and an upper surface 1100u. The lower surface 1100b is in contact with the upper surface of the third interlayer insulating layer 210, the inner surface 1100i defines the groove G (e.g., a portion of the groove G), the side surface 1100s is tapered in a forward direction with respect to the upper surface of the third interlayer insulating layer 210, and the upper surface 1100u is between the side surface 1100s and the inner surface 1100i.

The upper surface 1100u of the first layer 1100 may be inclined downwardly from the outside toward the inside where the groove G is located. Accordingly, a first vertical distance H1, which is from the upper surface of the inorganic insulating structure IL to a point where the side surface 1100s of the first layer 1100 meets the upper surface 1100u, may be greater than a second vertical distance H2 from the upper surface of the inorganic insulating structure IL to a point where the inner surface 1100i of the first layer 1100 meets the bottom surface of the second layer 1200. Because the depth of the groove G is less than the thickness of the first layer 1100, a third vertical distance H3 from the upper surface of the inorganic insulating structure IL to a portion corresponding to the center of the groove G is less than the second vertical distance H2.

Two second layers 1200 may be respectively located on two opposite sides with the groove G of the first layer 1100 therebetween. Each of the second layers 1200 respectively located on two opposite sides with the groove G therebetween may include the overhang portion P protruding over the groove G.

The second layer 1200 located on one side (e.g., the left side) of the groove G may include the overhang portion P extending (or protruding) toward the groove G from a point where the lower surface of the second layer 1200 meets the inner surface 1100i of the first layer 1100 defining the groove G. Similarly, the second layer 1200 located on the other side (e.g., the right side) of the groove G may include the overhang portion P extending (or protruding) toward the groove G from a point where the lower surface of the second layer 1200 meets the inner surface 1100i of the first layer 1100 defining the groove G. A length L of the overhang portion P, for example, the length L from a portion where the lower surface of the second layer 1200 meets the inner surface 1100i of the first layer 1100 defining the groove G to the edge (lateral surface) of the overhang portion P may in a range of about 0.2 micrometers to about 0.4 micrometers (e.g., 0.2 µm ≤ L ≤ 0.4 µm).

Each of the two second layers 1200 may extend to the upper surface of the inorganic insulating structure IL through the two opposite side surfaces 1100s of the first layer 1100. Each of the second layers 1200 may be in direct contact with the side surfaces 1100s of the first layer 1100 and the upper surface of the inorganic insulating structure IL.

An upper surface Pu of the overhang portion P may be located on an imaginary plane IPL parallel to an upper surface 100u of the substrate 100, or may be located on a plane different from the imaginary plane IPL. A first angle θ between the upper surface Pu of the overhang portion P and the imaginary plane IPL parallel to the upper surface 100u of the substrate 100 may have a range of about 0° to about 40° (e.g., 0°≤ θ ≤ 40°).

In one or more embodiments, the overhang portion P of each of the second layers 1200 may be tilted downwardly toward the groove G. As an example, a first angle θ between the upper surface Pu of the overhang portion P and the imaginary plane IPL parallel to the upper surface 100u of the substrate 100 may be greater than about 0° and may be equal to or less than about 40° (e.g., 0° < θ ≤ 40°). As an example, as shown in FIG. 8, the first angle θ may be greater than about 0° and may be equal to or less than about 30° (0°< θ ≤ 30°).

In one or more other embodiments, the first angle θ may be about 0°. As an example, as shown in FIG. 9, the upper surface Pu of the overhang portion P may be located on the imaginary plane IPL parallel to the upper surface 100u of the substrate 100.

As described above, in the case where the first angle θ has the range of about 0° to about 40° (0°< θ ≤ 40°), the likelihood of the overhang portion P being lifted from the first layer 1100 and separated from the first layer 1100 may be effectively reduced or prevented. Because the likelihood of the phenomenon of the overhang portion P being lifted is reduced or prevented, exfoliation of the first inorganic encapsulation layer 310 and the second inorganic encapsulation layer 330 may be reduced or prevented.

The protective layer 1115 may be located on the second layer 1200. The protective layer 1115 is located on the overhang portion P, and may be in direct contact with the overhang portion P. The protective layer 1115 may be located on the upper surface Pu and a lateral surface Ps of the overhang portion P. The protective layer 1115 may extend to overlap the side surface 1100s of the first layer 1100 and to overlap the upper surface of the inorganic insulating structure IL. The protective layer 1115 may reduce or prevent the likelihood of the length of the overhang portion P (e.g., eaves length) being shortened due to damage to the overhang portion P during the process of manufacturing the display panel 10 (see FIG. 7).

The protective layer 1115 may include a conductive material, for example, the same material as the pixel electrode 221 (see FIG. 6). The protective layer 1115 may be formed through a deposition process. A material forming the protective layer 1115 may be deposited inside the groove G, and as shown in FIGS. 8 and 9, there may be the first protective material layer 1116, which is the same as the protective layer 1115, at a bottom of the groove G.

As described above with reference to FIG. 7, the organic material layers included in the organic light-emitting diode OLED (see FIG. 6), for example, the first functional layer 222a and the second functional layer 222c, may be separated into a plurality of portions by the overhang structure OHS. As shown in FIGS. 8 and 9, each of the first functional layer 222a and the second functional layer 222c may include portions located on the overhang portions P and a portion located inside the groove G. A portion of the first functional layer 222a and the second functional layer 222c may be located on the protective layer 1115 over the overhang portion P, and another portion of the first functional layer 222a and the second functional layer 222c may be located on the first protective material layer 1116 at a bottom of the groove G.

Similarly, the opposite electrode 223 may be separated into a plurality of portions. As shown in FIGS. 8 and 9, the opposite electrode 223 may include portions located on the overhang portions P, and a portion located inside the groove G. A portion of the opposite electrode 223 may be located on a portion of each of the first functional layer 222a and the second functional layer 222c, and another portion of the opposite electrode 223 may be located on another portion of each of the first functional layer 222a and the second functional layer 222c at a bottom of the groove G.

Because the first inorganic encapsulation layer 310 has suitable step coverage, the first inorganic encapsulation layer 310 may continuously extend without being disconnected by the overhang structure OHS as shown in FIGS. 8 and 9. As an example, the first inorganic encapsulation layer 310 may continuously extend to overlap the upper surface Pu, the lateral surface Ps, and a bottom surface Pb of the overhang portion P. In one or more embodiments, the upper surfaces of the first inorganic encapsulation layer 310 may be in contact with each other between the adjacent overhang portions P. In this case, in a cross-sectional view, there may be a cavity CV as shown in FIG. 8. In one or more other embodiments, as shown in FIG. 9, the cavity CV may be omitted according to the thickness of the first inorganic encapsulation layer 310 and/or the gap between the overhang portions P.

Because the second inorganic encapsulation layer 330 has suitable step coverage, the second inorganic encapsulation layer 330 may continuously extend without being separated by the overhang structure OHS. As shown in FIGS. 8 and 9, the second inorganic encapsulation layer 330 may be in direct contact with the first inorganic encapsulation layer 310 on some overhang structure OHS among the overhang structures OHS shown in FIG. 7.

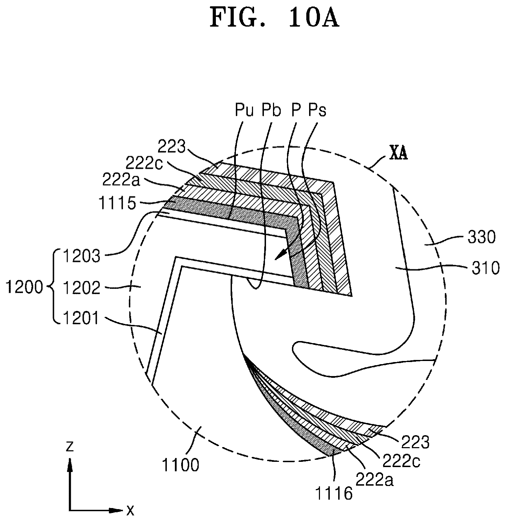

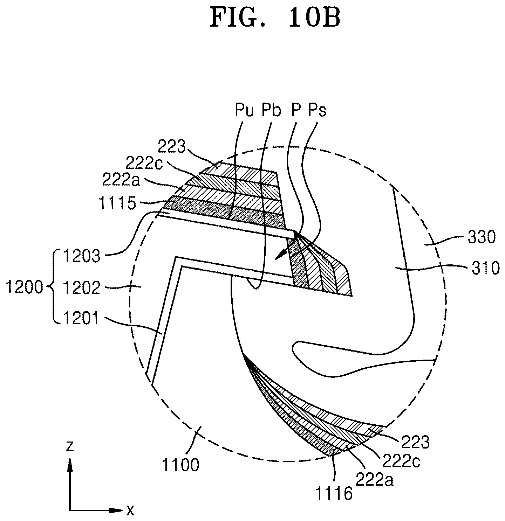

FIG. 10A is an excerpted cross-sectional view of a portion of the display panel 10 according to one or more embodiments, and is an enlarged view of a region XA of FIG. 8, and FIG. 10B is an excerpted cross-sectional view of a portion of the display panel 10 according to one or more other embodiments, corresponding to a modified one or more embodiments corresponding to FIG. 10A.

Referring to FIGS. 10A and 10B, the second layer 1200 may include a plurality of sub-layers 1201, 1202, and 1203 including different respective materials. As an example, the first sub-layer 1201 of the second layer 1200 may be a titanium layer, the second sub-layer 1202 may be an aluminum layer, and the third sub-layer 1203 may be a titanium layer.

In one or more embodiments, referring to FIG. 10A, the protective layer 1115 may continuously extend from the upper surface Pu of the overhang portion P to the lateral surface Ps to cover the lateral surface Ps of the overhang portion P of the second layer 1200, for example, the lateral surface of each of the first to third sub-layers 1201, 1202, and 1203.

In one or more other embodiments, because etching selectivities of the first to third sub-layers 1201, 1202, and 1203 are different from each other, the lateral surface Ps of the overhang portion P may have irregularities during the process of forming the second layer 1200, as shown in FIG. 10B. Due to the irregularities, a portion of the protective layer 1115 formed on the second layer 1200 located on the upper surface Pu of the overhang portion P, and a portion located on the lateral surface Ps of the overhang portion P may be discontinuous.

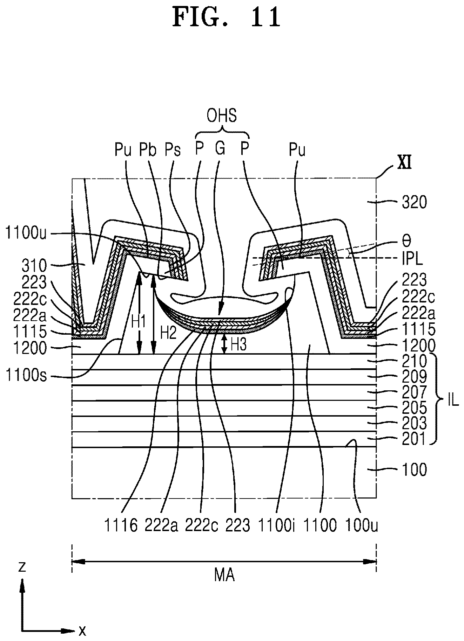

FIG. 11 is an excerpted cross-sectional view of a portion of the display panel 10 according to one or more embodiments and is an enlarged view of a region XI of FIG. 7. The overhang structure OHS shown in FIG. 11 shows an overhang structure OHS located between the display area DA (see FIG. 5) and the first partition wall 510 (see FIG. 7) that is closest to the display area DA.

Referring to FIG. 11, the overhang structure OHS located between the display area DA (see FIG. 5) and the first partition wall 510 (see FIG. 7) may also have the same structure described above with reference to FIG. 8. The overhang structure OHS may include overhang portions P protruding over the groove G of the first layer 1100.

In one or more embodiments, the upper surface 1100u of the first layer 1100 may be inclined downwardly toward the groove G. Accordingly, the first vertical distance H1 from the upper surface of the inorganic insulating structure IL to a point where the side surface 1100s of the first layer 1100 meets the upper surface 1100u may be greater than the second vertical distance H2 from the upper surface of the inorganic insulating structure IL to a point where the inner surface 1100i of the first layer 1100 meets the bottom surface of the second layer 1200. Because the depth of the groove G is less than the thickness of the first layer 1100, the third vertical distance H3 from the upper surface of the inorganic insulating structure IL to a portion corresponding to the center of the groove G is less than the second vertical distance H2.

The first angle θ between the upper surface Pu of the overhang portion P of the second layer 1200 located on the first layer 1100 and the imaginary plane IPL parallel to the upper surface 100u of the substrate 100 may have the range of about 0° to about 40° (e.g., 0°≤ θ ≤ 40°) as described above with reference to FIGS. 8 and 9. In one or more embodiments, the first angle θ between the imaginary plane IPL and the upper surface Pu of each of the overhang portions P may be, e.g., 0°≤ θ ≤ 30°.

Two second layers 1200 may be respectively located on two opposite sides with the groove G of the first layer 1100 therebetween. Each of the second layers 1200 may include the overhang portion P extending (or protruding) toward the groove G from a point where the lower surface of the second layer 1200 meets the inner surface 1100i of the first layer 1100 defining the groove G. The length of the overhang portion P may have a range of about 0.2 micrometers to about 0.4 micrometers.

The protective layer 1115 is located on the overhang portion P, and may be in direct contact with the overhang portion P. The protective layer 1115 may be located on the upper surface Pu and a lateral surface Ps of the overhang portion P. The protective layer 1115 may extend to overlap the side surface 1100s of the first layer 1100 and the upper surface of the inorganic insulating structure IL. The first protective material layer 1116 may include the same material as the protective layer 1115, and may be present at the bottom of the groove G.

As described above with reference to FIG. 7, the organic material layers included in the organic light-emitting diode OLED (see FIG. 6), for example, the first functional layer 222a and the second functional layer 222c, may be separated into a plurality of portions by the overhang structure OHS. As shown in FIG. 11, each of the first functional layer 222a and the second functional layer 222c may include portions located on the overhang portions P and a portion located inside the groove G. Similarly, the opposite electrode 223 may be separated into a plurality of portions.

The protective layer 1115, the first functional layer 222a, the second functional layer 222c, and the opposite electrode 223 on the overhang portion P are located on the upper surface Pu and the lateral surface Ps of the overhang portion P, and may be continuous as described above with reference to FIG. 10A or discontinuous as described with reference to FIG. 10B.

Because the first inorganic encapsulation layer 310 has suitable step coverage, the first inorganic encapsulation layer 310 may continuously extend without being disconnected by the overhang structure OHS as shown in FIG. 11. The organic encapsulation layer 320 is located on the first inorganic encapsulation layer 310 in the inner non-display area MA, and may overlap the overhang structure OHS as shown in FIG. 11.

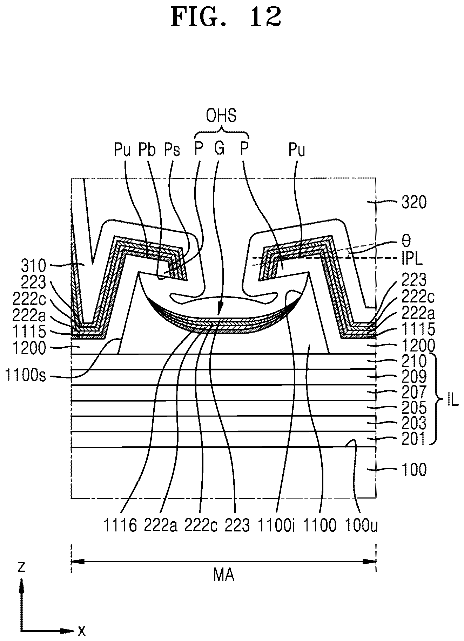

FIG. 12 is an excerpted cross-sectional view of a portion of the display panel 10 according to one or more other embodiments. FIG. 12 may correspond to an enlarged view of a region XI of FIG. 7 according to one or more other embodiments. The structure according to one or more embodiments shown in FIG. 12 is substantially the same as the structure described above with reference to FIG. 11, and is different in that the upper surface 1100u (see FIG. 11) of the first layer 1100 is not substantially present (e.g., is mostly omitted).

Referring to FIG. 12, the side surface 1100s of the first layer 1100 and the inner surface 1100i defining the groove G may meet each other, or may closely approach each other. The second layer 1200 may be located on the first layer 1100. The first angle θ between the upper surface Pu of the overhang portion P of the second layer 1200 and the imaginary plane IPL parallel to the upper surface 100u of the substrate 100 may have the range of about 0° to about 40° (e.g., 0°≤ θ ≤ 40°) as described above with reference to FIGS. 8 and 9. In embodiments, the first angle θ may be, e.g., 0°≤ θ ≤ 30°.

The protective layer 1115, the first functional layer 222a, the second functional layer 222c, and the opposite electrode 223 are the same as those described above with reference to FIG. 11. The first inorganic encapsulation layer 310 may continuously extend without being separated by the overhang structure OHS. The organic encapsulation layer 320 is located on the first inorganic encapsulation layer 310 in the inner non-display area MA, and may overlap the overhang structure OHS as shown in FIG. 11. Among structures shown in FIG. 12, same structures as those of FIG. 11 are replaced with the structures described above with reference to FIG. 11.

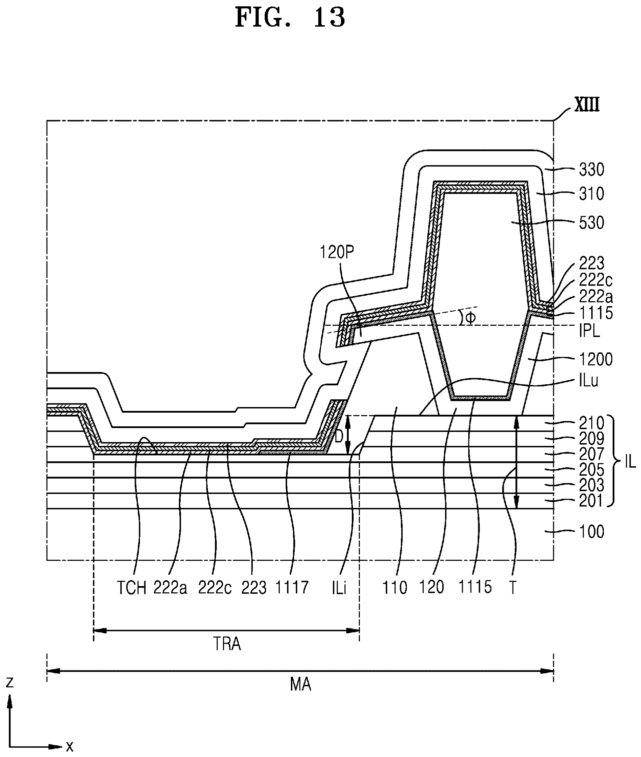

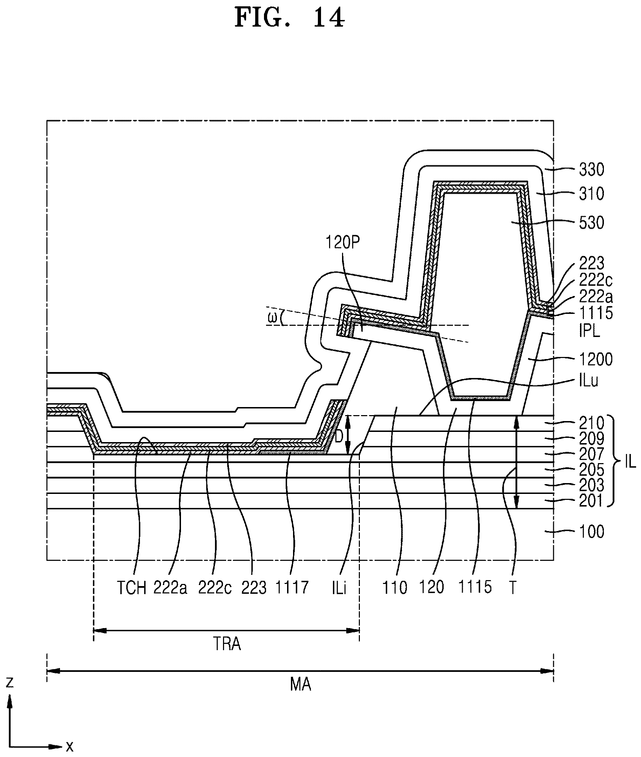

FIG. 13 is an excerpted cross-sectional view of a portion of the display panel 10 according to one or more embodiments and is an enlarged view of a region XIII of FIG. 7, and FIG. 14 is an excerpted cross-sectional view of a portion of a display panel 10 according to one or more other embodiments, corresponding to an enlarged view of the region XIII of FIG. 7 according to one or more other embodiments.

Referring to FIG. 13, the trench TCH having a shape recessed (concave) with respect to an upper surface ILu of the inorganic insulating structure IL may be located in the inner non-display area MA. The trench area TRA is a region of the inner non-display area MA in which the trench TCH is located, and may be close to the opening area OA, as described above with reference to FIG. 7. The trench TCH may have a closed loop shape surrounding the opening area OA entirely in a plan view.

A depth D of the trench TCH may be less than a sum T of the thicknesses of the inorganic insulating structure IL. In one or more embodiments, it is shown in FIG. 13 that the trench TCH passes through the upper surface and lower surface of the third interlayer insulating layer 210, the upper surface and lower surface of the second gate-insulating layer 209, and the upper surface of the second interlayer insulating layer 207, and the surface defining the bottom of the trench TCH is located between the upper surface and lower surface of the second interlayer insulating layer 207. However, the disclosure is not limited thereto. In one or more other embodiments, when the depth D of the trench TCH is less than the sum T of the thicknesses of the inorganic insulating structure IL, the trench TCH may be formed by removing a plurality of layers selected from among the layers included in the inorganic insulating structure IL.

The insulating layer 110 may be located to overlap the trench TCH. The trench TCH includes a first edge portion (e.g., a left edge portion in FIG. 13) relatively closer to the opening area OA, and a second edge portion (e.g., a right edge portion in FIG. 13) opposite to the first edge portion, and each of the first edge portion and the second edge portion may form a step difference with respect to the upper surface of the inorganic insulating structure IL. The first edge portion (e.g., the left edge portion in FIG. 13) is relatively closer to the opening area OA, and the second edge portion (e.g., the right edge portion in FIG. 13) is opposite to the first edge portion and may be relatively closer to the display area DA (see FIG. 5).

The insulating layer 110 may cover a step difference relatively closer to the partition wall. As an example, it is shown in FIG. 13 that the insulating layer 110 overlaps a step difference of the second edge portion of the trench TCH relatively closer to the third partition wall 530. The insulating layer 110 may cover a step difference of the second edge portion, for example, a step difference formed by the upper surface ILu of the inorganic insulating structure IL and the inner lateral surface ILi of the inorganic insulating structure IL defining the trench TCH. A portion of the insulating layer 110 may be located on the upper surface of the inorganic insulating structure IL, and another portion may be located on the trench TCH. The insulating layer 110 may include an organic insulating material. In one or more embodiments, the insulating layer 110 may be formed concurrently or substantially simultaneously during the same process as the forming the first layer 1100.

The metal layer 120 may be located on the insulating layer 110. The metal layer 120 may include aluminum (Al), copper (Cu), and/or titanium (Ti), and may include a single layer or a multi-layer including the above materials. As an example, the metal layer 120 may have a triple-layered structure of titanium layer/aluminum layer/titanium layer.

The first overhang portion 120P of the metal layer 120 may protrude toward the trench TCH from a point where a lateral surface of the insulating layer 110, which is tapered forward with respect to the surface defining the bottom of the trench TCH, meets the lower surface of the metal layer 120. Like the overhang portion P described above with reference to FIG. 8 and the like, the length of the first overhang portion 120P may have a range of about 0.2 micrometers to about 0.4 micrometers.

The protective layer 1115 may be located on the lateral surface and upper surface of the first overhang portion 120P, and may be in direct contact with the lateral surface and upper surface of the first overhang portion 120P. In one or more embodiments, as shown in FIG. 13, the protective layer 1115 may continuously cover the lateral surface and upper surface of the first overhang portion 120P. In one or more other embodiments, as described with reference to FIG. 10B, the protective layer 1115 may be discontinuous on the lateral surface and upper surface of the first overhang portion 120P.

The second protective material layer 1117 may be located on the lateral surface of the insulating layer 110 and the surface defining the bottom of the trench TCH. The second protective material layer 1117 may be in direct contact with the lateral surface of the insulating layer 110 and the surface defining the bottom of the trench TCH. The second protective material layer 1117 may include the same material as the protective layer 1115.

Due to the first overhang portion 120P, each of the first functional layer 222a, the second functional layer 222c, and the opposite electrode 223 may be separated into a plurality of portions. As shown in FIG. 13, each of the first functional layer 222a, the second functional layer 222c, and the opposite electrode 223 may include a portion located on the first overhang portion 120P and a portion located at the bottom of the trench TCH. A portion of the first functional layer 222a located at the bottom of the trench TCH may be in direct contact with the surface defining the bottom of the trench TCH.

Similar to the upper surface of the overhang portion P described above with reference to FIGS. 8 and 9, the first overhang portion 120P may be tilted downward to have a corresponding angle (e.g., preset angle) with respect to the imaginary plane IPL substantially parallel to the upper surface of the substrate 100 or parallel to the upper surface of the substrate 100. In one or more embodiments, as shown in FIG. 13, the first overhang portion 120P may extend toward the trench TCH, and may be tilted downward. In one or more other embodiments, the upper surface of the first overhang portion 120P may be located on the imaginary plane IPL parallel to the upper surface of the substrate 100. A second angle ϕ between the upper surface of the first overhang portion 120P and the imaginary plane IPL parallel to the upper surface of the substrate 100 may have a range of about 0° to about 40° (e.g., 0°≤ ϕ ≤ 40°). In one or more embodiments, the second angle ϕ may have a range of about 0° to about 30° (e.g., 0°≤ ϕ ≤ 30°).

In one or more other embodiments, as shown in FIG. 14, the upper surface of the first overhang portion 120P may extend toward the trench TCH, and may be tilted upward. As shown in FIG. 14, a third angle ω between the upper surface of the first overhang portion 120P and the imaginary plane IPL parallel to the upper surface of the substrate 100 may have a range greater than about 0° and equal to or less than about 10° (e.g., 0°< ω ≤ 10°). Like the one or more embodiments corresponding to FIG. 13, in a case of the one or more embodiments corresponding to FIG. 14, compared to the case where the first overhang portion 120P is tilted downward, the first overhang portion 120P may be relatively separated from the insulating layer 110 and lifted upwardly, but when the range of the third angle ω is satisfied, the occurrence of the above issue may be reduced.

Because the first inorganic encapsulation layer 310 has suitable step coverage, the first inorganic encapsulation layer 310 may continuously extend without being disconnected by the overhang structure OHS as shown in FIGS. 8 and 9.

As shown in FIG. 13, in one or more embodiments, because the display panel 10 includes the trench TCH, cracks occurring around the opening area OA (see FIG. 7) may be reduced or may be prevented from progressing toward the display area DA (see FIG. 7) during the process of forming the display panel 10. The progression of the cracks may be prevented or reduced by the structure of the trench TCH. The insulating layer 110 overlapping the trench TCH and the second protective material layer 1117 including a conductive material may absorb impacts progressing toward the display area DA (see FIG. 7), or may reduce or minimize the propagation of cracks together with the trench TCH.

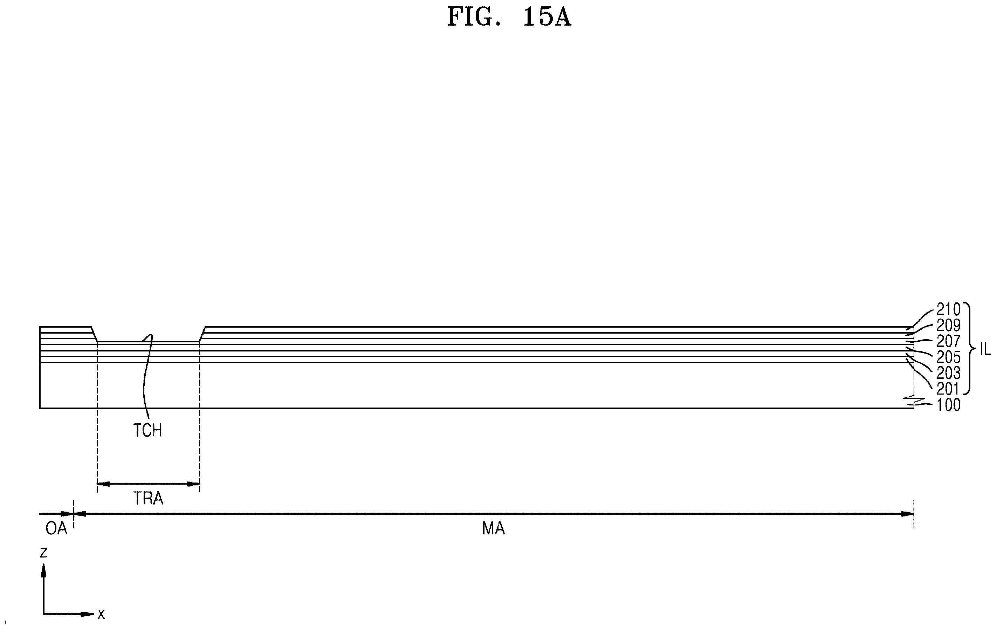

FIGS. 15A to 15G are cross-sectional views of the inner non-display area MA in the process of manufacturing the display panel 10 according to one or more embodiments.

Referring to FIG. 15A, the inorganic insulating structure IL is formed on the substrate 100. The inorganic insulating structure IL may include the buffer layer 201, the first gate-insulating layer 203, the first interlayer insulating layer 205, the second interlayer insulating layer 207, the second gate-insulating layer 209, and the third interlayer insulating layer 210. The inorganic insulating structure IL may be formed in the display area DA (see FIG. 5), the inner non-display area MA, and the opening area OA.

The trench TCH is formed in the trench area TRA, which is a partial region of the inner non-display area MA adjacent to the opening area OA, by removing a portion of the inorganic insulating structure IL. The depth of the trench TCH may be less than the sum of the thicknesses of the inorganic insulating structure IL. The trench TCH may surround the opening area OA entirely in a plan view.

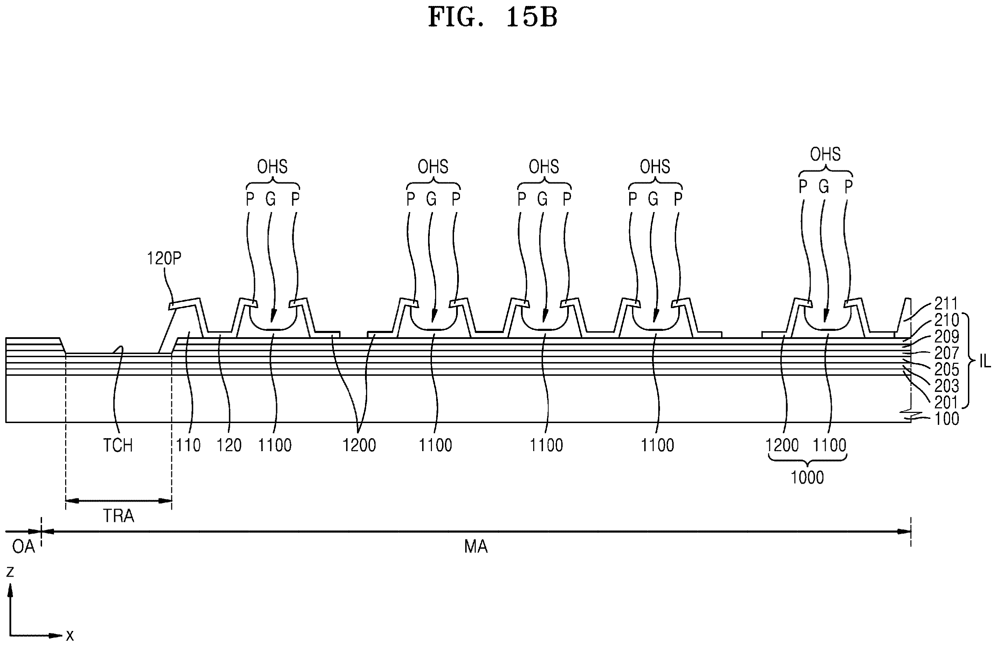

Referring to FIG. 15B, a plurality of overhang structures OHS are formed in the inner non-display area MA. The overhang structure OHS may be formed in the multi-layer 1000 including the first layer 1100 and the second layer 1200. A overhang portion (e.g., the first overhang portion 120P) is formed in the metal layer 120 on the insulating layer 110. The insulating layer 110 may overlap the trench TCH.

The insulating layer 110 is formed to overlap a step difference between the upper surface of the inorganic insulating structure IL and the trench TCH. The metal layer 120 on the insulating layer 110 may include the first overhang portion 120P. Corresponding structures of the insulating layer 110 overlapping the trench TCH and the metal layer 120 may be the same as those described with reference to FIGS. 13 and 14. The insulating layer 110 and the metal layer 120 may be respectively formed during the same process as the forming the first layer 1100 and the second layer 1200.

The first layers 1100 may be apart from each other in the inner non-display area MA. Each of the first layers 1100 may include the groove G, and the second layers 1200 including the overhang portion P protruding over the groove G may be located on two opposite sides around the groove G. The second layer 1200 may pass through the lateral surface of the first layer 1100, and may be in direct contact with the upper surface (e.g., the upper surface of the third interlayer insulating layer 210) of the inorganic insulating structure IL.

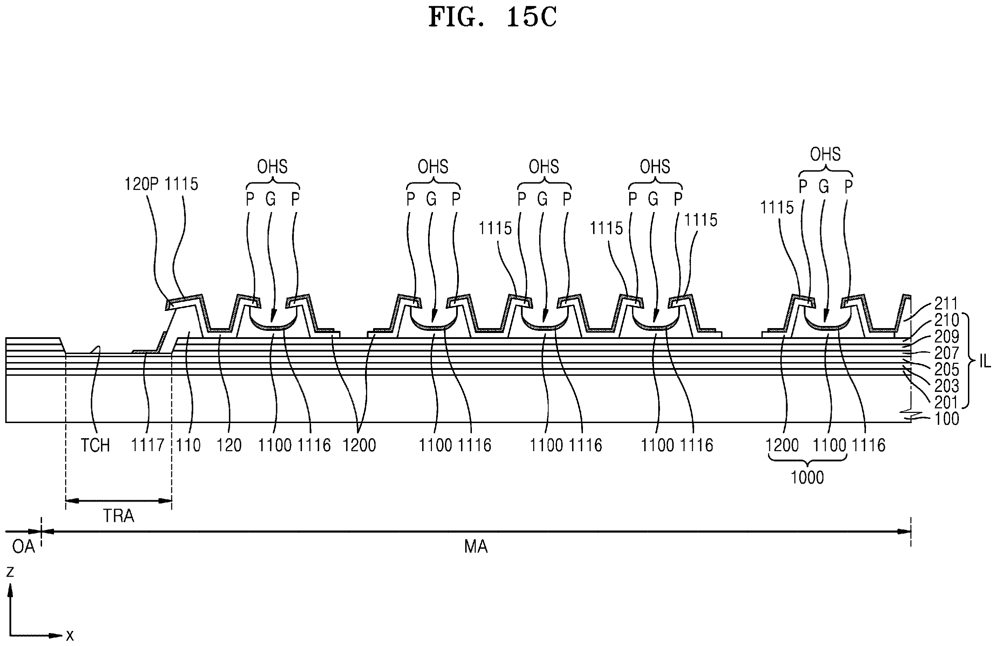

Referring to FIG. 15C, the protective layer 1115 may be formed on the first overhang portion 120P and the overhang portion P. The protective layer 1115 may include a conductive material. The protective layer 1115 may be formed during the process of forming the pixel electrode 221. The protective layer 1115 may include the same material as the pixel electrode 221. The material forming the protective layer 1115 may be deposited in the inner non-display area MA. Accordingly, due to the overhang portion P, the first protective material layer 1116 may be at an interior of the groove G, wherein the first protective material layer 1116 is separated from the protective layer 1115 and includes the same material as the protective layer 1115. The second protective material layer 1117 may be formed in the trench TCH, wherein the second protective material layer 1117 includes the same material as the protective layer 1115. The second protective material layer 1117 may be in direct contact with the surface defining the bottom of the trench TCH and the lateral surface of the insulating layer 110.

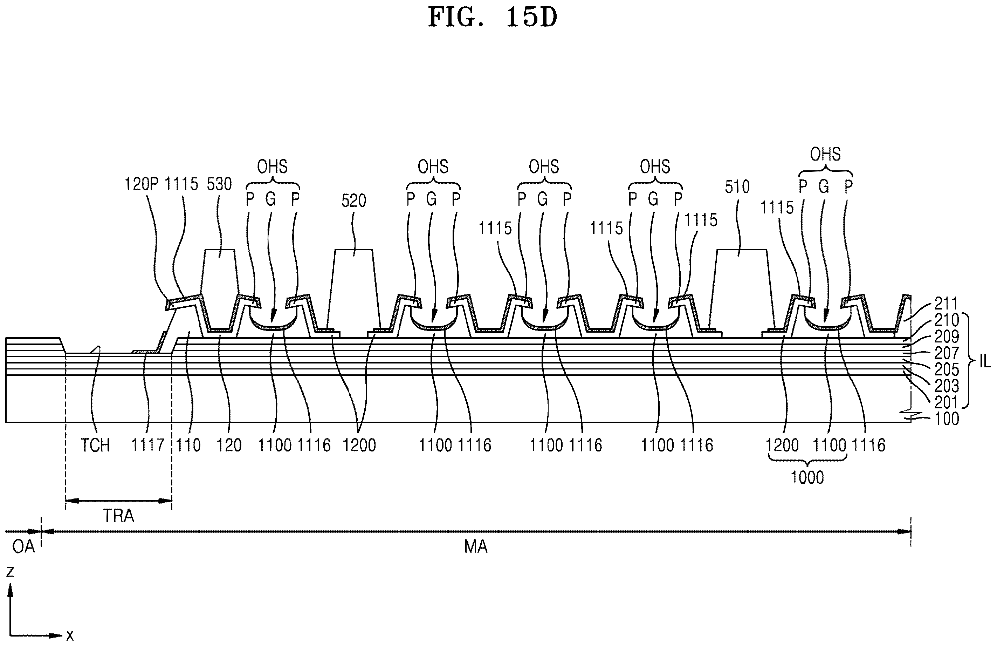

Referring to FIG. 15D, the first partition wall 510, the second partition wall 520, and the third partition wall 530 apart from each other may be formed in the inner non-display area MA.

Each of the first partition wall 510, the second partition wall 520, and the third partition wall 530 may surround the opening area OA entirely in a plan view. The first partition wall 510 may be relatively closer to the display area DA (see FIG. 5), and the third partition wall 530 may be relatively closer to the opening area OA.

The first partition wall 510 may be located between two overhang structures OHS, and may overlap (or cover) an end of the second layer 1200. The first partition wall 510 may overlap (or cover) an end of the protective layer 1115 on the second layer 1200. The second partition wall 520 may be located between two overhang structures OHS, and may overlap (or cover) an end of the second layer 1200. The second partition wall 520 may overlap (or cover) an end of the protective layer 1115 on the second layer 1200. The third partition wall 530 may be located on a connection portion of the metal layer 120 and the second layer 1200.

The width of the second partition wall 520 may be less than the width of the first partition wall 510, and the width of the third partition wall 530 may be less than the width of the second partition wall 520. Each of the first partition wall 510, the second partition wall 520, and the third partition wall 530 may include an organic insulating material. Each of the first partition wall 510, the second partition wall 520, and the third partition wall 530 may include the same material as the bank layer 215 (see FIG. 6) and/or the spacer 217 (see FIG. 6) of the display area DA (see FIG. 5).

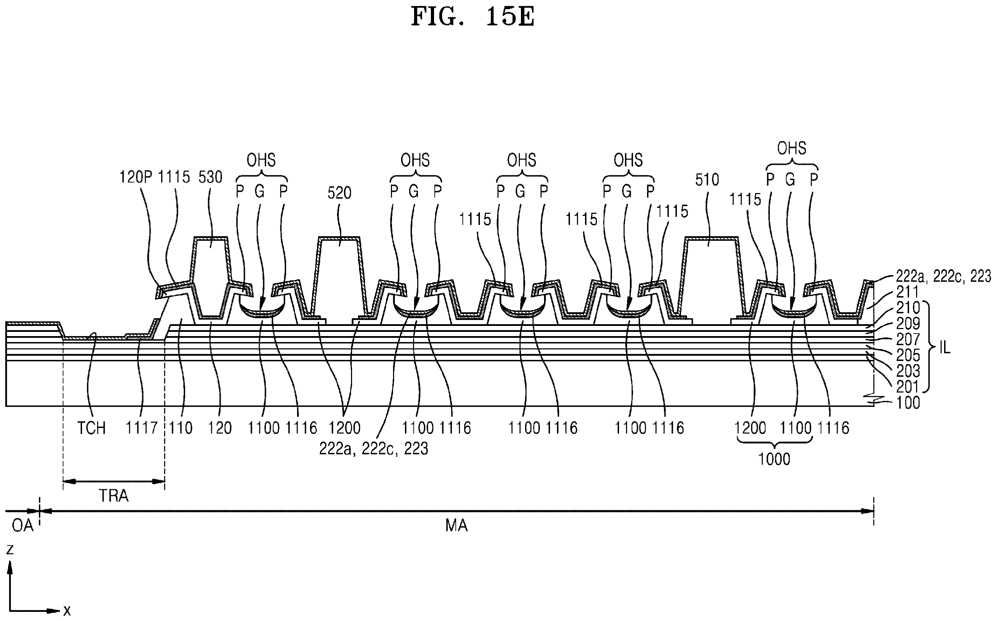

Referring to FIG. 15E, the first and second functional layers 222a and 222c, and the opposite electrode 223 of the organic light-emitting diode OLED (see FIG. 6) may be formed. The first and second functional layers 222a and 222c, and the opposite electrode 223 may be formed through a thermal deposition method. Each of the first and second functional layers 222a and 222c, and the opposite electrode 223 may be also deposited on the inner non-display area MA. However, due to the eaves structures of the first overhang portion 120P and the overhang portion P formed in the inner non-display area MA, each of the first and second functional layers 222a and 222c, and the opposite electrode 223 may be separated into a plurality of portions. Accordingly, external moisture may be reduced, or may be prevented from progressing toward the organic light-emitting diode OLED (see FIG. 6) through the first and second functional layers 222a and 222c, and the opposite electrode 223.

With regard to this, it is shown in FIG. 15E that each of the first and second functional layers 222a and 222c includes a portion located on the overhang portion P, a portion at a bottom of the groove G, a portion located on the first overhang portion 120P, and a portion located at the bottom of the trench TCH. Likewise, the opposite electrode 223 may also include a portion located on the overhang portion P, a portion at a bottom of the groove G, a portion located on the first overhang portion 120P, and a portion located at the bottom of the trench TCH.

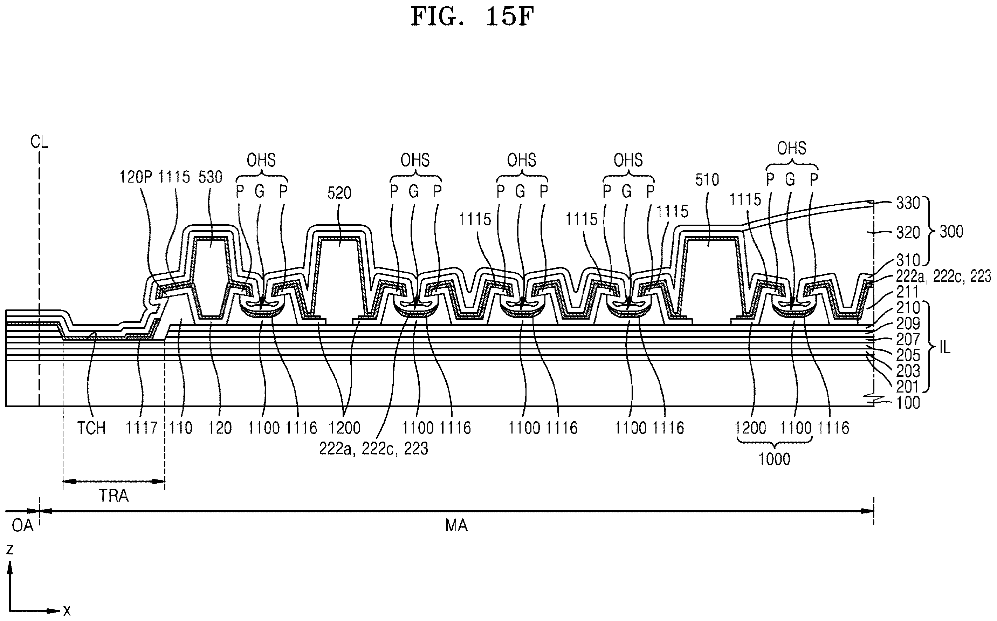

Referring to FIG. 15F, the encapsulation layer 300 may be formed. The first inorganic encapsulation layer 310 may be formed through chemical vapor deposition. Because the first inorganic encapsulation layer 310 has a relatively excellent step coverage, the first inorganic encapsulation layer 310 may continuously cover the upper surface, lateral surface, and bottom surface of the first overhang portion 120P and the overhang portion P without being separated by the first overhang portion 120P and the overhang portion P. The first inorganic encapsulation layer 310 may continuously cover the upper surface, lateral surface, and bottom surface of the first overhang portion 120P and the overhang portion P. The first inorganic encapsulation layer 310 may also continuously cover the lateral surface and upper surface of the first to third partition walls 510, 520, and 530.

Then, the organic encapsulation layer 320 may be formed by coating and curing monomer. The first to third partition walls 510, 520, and 530 are intended to control a flow of the monomer. In one or more embodiments, as shown in FIG. 15F, the edge of the organic encapsulation layer 320 may be located on one side of the first partition wall 510. In one or more other embodiments, a portion of the organic encapsulation layer 320 may be present between the first partition wall 510 and the second partition wall 520.

The second inorganic encapsulation layer 330 may be formed on the organic encapsulation layer 320, and may be in direct contact with the first inorganic encapsulation layer 310 in the inner non-display area MA.

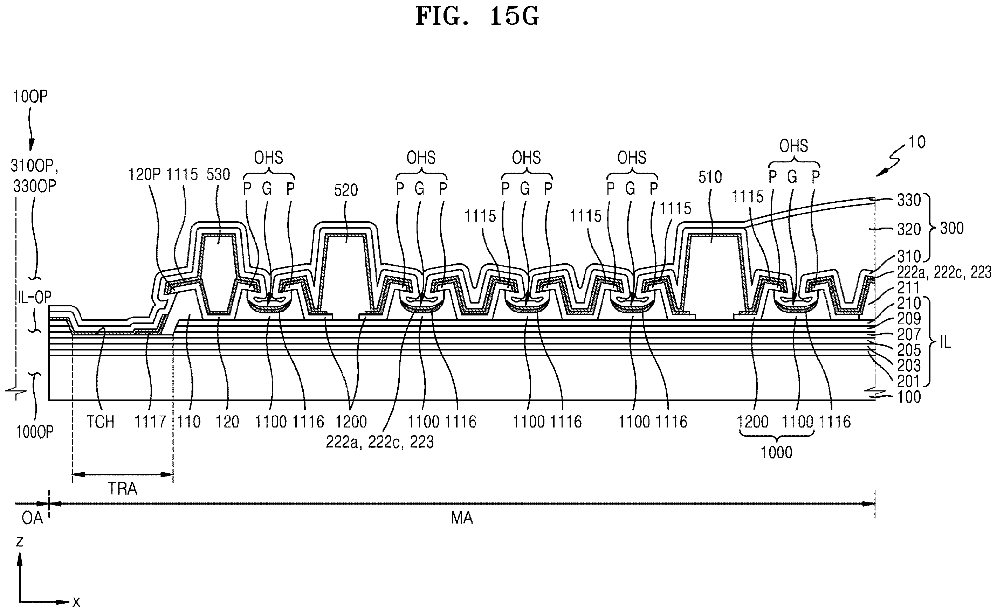

Referring to FIGS. 15F and 15G, when elements located in the opening area OA are removed along a cutting line CL using a laser beam and the like, the opening 10OP of the display panel 10 may be formed in the opening area OA.

Cracks may occur around the opening area OA due to impacts occurring during the cutting process of removing the elements located in the opening are OA. Although the cracks or impacts may progress toward the display area DA, because the display panel 10 includes the structure of the trench TCH, damage to the display panel 10 due to the cracks or impacts may be reduced or prevented. The insulating layer 110 and the second protective material layer 1117 overlapping the trench TCH may reduce or prevent damage to the display panel 10 due to the cracks or impacts together with the trench TCH.

The display panel according to the disclosed embodiments may reduce or prevent issues of crack occurrence and the like in the non-display area. The display panel according to the disclosed embodiments may reduce or prevent the inorganic encapsulation layers from being exfoliated around the opening area. The display panel according to the disclosed embodiments may reduce or prevent external impurities, such as moisture around the opening area from damaging the display elements. However, this aspect is provided as an example, and aspects according to embodiments are described in detail in the description above.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the appended claims.

## Claims

1. A display panel (10) comprising:
a substrate (100) comprising an upper surface (100u), and a lower surface opposite the upper surface (100u), and defining an opening (100OP) passing through the upper surface (100u) and the lower surface;
an inorganic insulating structure (IL) comprising inorganic insulating layers above the upper surface (100u) of the substrate (100);
light-emitting diodes (LED) above an upper surface of the inorganic insulating structure (IL), and defining a display area (DA) surrounding the opening (100OP) in a plan view;
an encapsulation layer (300) above the light-emitting diodes (LED), and comprising an inorganic encapsulation layer (310, 330) and an organic encapsulation layer (320);
a trench (TCH) in a non-display area (PA) between the opening (100OP) of the substrate (100) and the display area (DA), and concavely defined to have a step difference (D) with respect to the upper surface of the inorganic insulating structure (IL);
an insulating layer (110) covering the step difference (D); and
a metal layer (120) above the insulating layer (110), and comprising a first overhang portion (120P) that protrudes toward the trench (TCH) more than a lateral surface of the insulating layer (110).

2. The display panel (10) of claim 1, wherein the insulating layer (110) comprises an organic insulating material.

3. The display panel (10) of claim 1 or 2, wherein at least one of the light-emitting diodes (LED) comprises a pixel electrode (221), an opposite electrode (223) over the pixel electrode (221), and an intermediate layer (222) between the pixel electrode (221) and the opposite electrode (223).

4. The display panel of claim 3, wherein the intermediate layer (222) comprises at least one organic material layer comprising a first portion on the first overhang portion (120P), and a second portion at a bottom of the trench (TCH) and separated from the first portion by the first overhang portion (120P).

5. The display panel of any one of the preceding claims, further comprising:
a protective layer (1115) above the first overhang portion (120P).

6. The display panel (10) of claim 5, further comprising:
a protective material layer (1117) in the trench (TCH), separated from the protective layer (1115), and comprising a same material as the protective layer (1115),
wherein the lateral surface of the insulating layer (110) is inclined with respect to a bottom of the trench (TCH), and
wherein the protective material layer (1117) directly contacts the lateral surface of the insulating layer (110).

7. The display panel (10) of claim 5 or 6, wherein the protective layer (1115) comprises a conductive material.

8. The display panel (10) of any one of the preceding claims, wherein an upper surface of the first overhang portion (120P) is substantially parallel to the substrate (100) or is tilted downward.

9. The display panel (10) of any one of the preceding claims, further comprising:
a partition wall (510, 520, 530) in the non-display area (PA), surrounding the opening (100OP) of the substrate (100) in the plan view, and between the trench (TCH) and the display area (DA).

10. The display panel (10) of any one of the preceding claims, further comprising:
a first layer (1100) between the trench (TCH) and the display area (DA), and defining a groove (G) therein.

11. The display panel (10) of claim 10, further comprising:
a pair of second layers (1200) above the first layer (1100), and comprising an overhang portion (P) protruding toward the groove (G) from a point at which a lower surface of one of the second layers (1200) meets an inner surface (1100i) of the first layer (1100) defining a portion of the groove (G).

12. The display panel (10) of claim 10 or 11, wherein the first layer (1100) comprises a same material as the insulating layer (110)

13. The display panel (10) of claim 11 or 12, wherein the second layers (1200) comprise a same material as the metal layer (120).

14. An electronic apparatus (1) comprising:
a display panel (10) of any one of the preceding claims, further comprising an opening area (OA), wherein the opening (100OP) corresponds to the opening area (OA) and the display area (DA) surrounds the opening area (OA) in a plan view; and
a component (70) below the display panel (10) and overlapping the opening area (OA) of the display panel (10).

15. The electronic apparatus (1) of claim 14, wherein the component (70) comprises a camera or a sensor.
